# EUROPÄISCHE PATENTSCHRIFT

(11) **EP 1 636 294 B1**
(45) Veröffentlichungstag und Bekanntmachung des Hinweises auf die Patenterteilung: **28.03.2007**
(21) Anmeldenummer: 04738768.3
(22) Anmeldetag: 18.06.2004
(51) Int. Cl.: C08G 85/00

(54) **SYNTHESEVERFAHREN FÜR EINE VERBINDUNG ZUR BILDUNG EINER SELBSTORGANISIERENDEN MONOLAGE, VERBINDUNG ZUR BILDUNG EINER SELBSTORGANISIERENDEN MONOLAGE UND EINE SCHICHTSTRUKTUR FÜR EIN HALBLEITERBAUELEMENT**
SYNTHESIS METHOD FOR A COMPOUND USED TO FORM A SELF-ASSEMBLED MONOLAYER, COMPOUND FOR FORMING A SELF-ASSEMBLED MONOLAYER, AND LAYER STRUCTURE FOR A SEMICONDUCTOR COMPONENT
PROCEDE DE SYNTHESE D'UN COMPOSE DESTINE A FORMER UNE MONOCOUCHE AUTO-ORGANISEE, COMPOSE DESTINE A FORMER UNE MONOCOUCHE AUTO-ORGANISEE ET STRUCTURE DE COUCHES DESTINEE A UN COMPOSANT A SEMICONDUCTEURS

(30) Priorität: 20.06.2003 DE 10328810
(43) Veröffentlichungstag der Anmeldung: 22.03.2006
(73) Patentinhaber: Qimonda AG, 81739 München (DE)
(72) Erfinder: EFFENBERGER, Franz, 70597 Stuttgart (DE); SCHÜTZ, Markus, 70193 Stuttgart (DE); MAISCH, Steffen, 70839 Gerlingen (DE); SEIFRITZ, Steffen, 45968 Gladbeck (DE); SCHMID, Günter, 91334 Hemhofen (DE); HALIK, Marcus, 91058 Erlangen (DE); KLAUK, Hagen, 70195 Stuttgart (DE); ZSCHIESCHANG, Ute, 70195 Stuttgart (DE); HOLBERG, Stefan, 66123 Saarbrücken (DE)
(74) Vertreter: Gross, Felix
(86) Internationale Anmeldenummer: PCT/DE2004/001319
(87) Internationale Veröffentlichungsnummer: WO 2004/113419

(56) Entgegenhaltungen:
- NATARAJAN BALACHANDER, CHAIM N. SUKENIK: "Monolayer Transformation by Nucleophilic Substitution: Applications to the Creation of New Monolayer Assemblies" LANGMUIR, Bd. 6, Nr. 11, November 1990 (1990-11), Seiten 1621-1627, XP002313921 ISSN 0743-7463
- TILLMAN N ET AL: "A novel self-assembling monolayer film containing a sulfone-substituted aromatic group" LANGMUIR, AMERICAN CHEMICAL SOCIETY, NEW YORK, NY, US, Bd. 6, 1990, Seiten 1512-1518, XP002300327 ISSN: 0743-7463
- BARNESS, YITZHAK ET AL: "Functionalized Silanes for the Preparation of Siloxane-Anchored Monolayers" LANGMUIR , 16(1), 247-251 CODEN: LANGD5; ISSN: 0743-7463, 2000, XP002313922
- GERSHEWITZ ET AL: "Effect of Molecule-Molecule Interaction on the Electronic Properties of Molecularly Modified Si/SiOx Surfaces" JOURNAL OF PHYSICAL CHEMISTRY. B, MATERIALS, SURFACES, INTERFACES AND BIOPHYSICAL, WASHINGTON, DC, US, Bd. 108, Nr. 2, 2004, Seiten 664-672, XP002299962 ISSN: 1089-5647

## Beschreibung

Die Erfindung betrifft ein Syntheseverfahren für eine Verbindung zur Bildung einer selbstorganisierenden Monolage gemäß Anspruch 1, eine Verbindung zur Bildung einer selbstorganisierenden Monolage gemäß Anspruch 12 und eine Schichtstruktur für ein Halbleiterbauelement gemäß Anspruch 13.

Zunehmend werden Halbleiterbauelemente unter Verwendung organischer Materialien hergestellt. Zum Beispiel sind Feldeffekttransistoren auf der Basis organischer Halbleiter (OFET) für eine Vielzahl elektronischer Anwendungen von Interesse. Insbesondere sind damit niedrige Fertigungskosten, flexible oder unzerbrechliche Substrate, oder die Herstellung von Transistoren und integrierten Schaltungen über große aktive Flächen möglich. Zum Beispiel eignen sich organische Feldeffekt-Transistoren als Pixel-Steuerelemente in Aktiv-Matrix-Bildschirmen oder für die Herstellung von extrem preiswerten integrierten Schaltungen, wie sie zum Beispiel für die aktive Kennzeichnung und Identifizierung von Waren und Gütern zum Einsatz kommen.

Da sich mit organischen Feldeffekttransistoren komplexe Schaltungen aufbauen lassen, bestehen zahlreiche Anwendungsmöglichkeiten. So gilt beispielsweise die Einführung von RF-ID (RF-ID: radio frequency identification) Systemen basierend auf dieser Technologie als potentieller Ersatz für den störanfälligen und nur in direktem Sichtkontakt zum Scanner anwendbaren Barcode. Passive RF-ID Systeme beziehen ihre Energie aus dem eingestrahlten Wechselfeld. Der mögliche Abstand zwischen Lesegerät und Transponder hängt dabei von der abgestrahlten Leistung und dem Energiebedarf des Transponders ab. Siliziumbasierte Transponder arbeiten deshalb bei Versorgungsspannungen um 3V. Produkte, die einen siliziumbasierten Chip enthalten, sind für viele Anwendungen zu teuer. Beispielsweise kommt für die Kennzeichnung von Lebensmitteln (Preis, Verfallsdatum etc.) ein siliziumbasiertes Ident-Tag nicht in Betracht.

Organische Feldeffekttransistoren bestehen normalerweise aus mindestens vier verschiedenen, übereinander aufgebrachten Schichten: einer Gateelektrode, einem Dielektrikum, einer Source-Drain-Kontaktschicht und einem organischen Halbleiter. Die Reihenfolge der Schichten kann dabei variieren. Damit die Funktionalität entsteht, müssen die einzelnen Lagen strukturiert werden, was relativ aufwändig ist.

Polymere bzw. organische Halbleiter bieten das Potential, dass billige Drucktechniken zu ihrer Strukturierung und Applikation eingesetzt werden können. Das Gatepotential zur Steuerung der organischen Feldeffekttransistoren kann umso kleiner gewählt werden, je dünner das Gatedielektrikum (d.h. eine dielektrische Schicht) hergestellt werden kann.

In der Polymerelektronik wird die Dicke des Gatedielektrikums im Allgemeinen dahingehend optimiert, dass die Lösung eines Polymers immer dünner ausgeschleudert bzw. aufgedruckt wird (top-down). Diese Verfahrensweise stößt jedoch an ihre Grenzen, wenn Schichtdicken kleiner als 50 nm erzielt werden sollen.

Es ist bekannt, Schichten für organische Feldeffekttransistoren mittels selbstorganisierenden Schichten aus molekularen Monolagen aufzubauen (SAM: Self-Assembled Monolayers).

In den Artikeln von J. Collet, D. Vuillaume; "Nano-field effect transistor with an organic self-assembled monolayer as gate insulator", Applied Physics Letters 73 (1998) 2681; J. Collet, S. Lenfant, D. Vuillaume, O. Bouloussa, F. Rondelez, J. M. Gay, K. Kham, C. Chevrot; "High anisotropic conductivity in organic insulator / semiconductor monolayer heterostructure", Applied Physic Letters 76 (2000) 1339 und J. Collet, O. Tharaud, A. Chapoton, D. Vuillaume; "Lowvoltage, 30 nm channel length, organic transistors with a self-assembled monolayer as gate insulating films", Applied Physics Letters 76 (2000) 1941 werden solche Schichten beschrieben.

Auch in den Artikeln von Pradyt Ghosh, Richard M: Crooks; "Covalent Grafting of a Pattered, Hyperbranched Polymer onto Plastic Substrate Using Microcontact Printing", J. Am. Chem. Soc. 121 (1999) 8395 -8306 und William M. Lackowski, Pradyut Ghosh, Richard M. Crooks; "Micron-Scale Patterning of Hyperbranched Polymer Films by Micro- Contact Printing;", J. Am. Chem. Soc. 121 (1999) 1419-1420, sowie dem US-Patent 4,539,061 wird auf diese Schichten eingegangen.

In den Artikeln von Collet et al. werden Materialien beschrieben, mit denen sich Transistoren mit SAM-Schichten aufbauen lassen. Dabei bilden Vinyl-terminierte Silane als Ankergruppen auf hydroxylhaltigen Substratflächen eine SAM aus. Anschließend wird diese SAM chemisch nachbehandelt, um weitere Moleküle chemisch an die SAM zu binden (siehe US-A 4,539,061) oder es werden Oberflächen hergestellt, die eine weitere Prozessierung zulassen (siehe Artikel von Collet, Tharaud et al.).

Dabei ist es nachteilig, dass diese Schichten nicht ohne Nachbehandlung eine dichte Dielektrikumsschicht bilden. Die eingesetzten chemischen Nachbehandlungen setzt bei einer Reaktionszeit von 48 bis 120 Stunden nur 70 bis 90% der Endgruppen um. Diese chemische Nachbehandlung dauert für die Fertigung hoher Stückzahlen zu lange.

Prinzipiell ist es auch möglich, Polymere über mehrere Koordinationsstellen an eine Oberfläche zu binden (Self-Assembled Polymers). Dies ist aus der US-A 5,728,431, US-A 5,783,648 (1998) und der US-A 5,686,549 bekannt.

Der vorliegenden Erfindung liegt die Aufgabe zugrunde, ein effizientes Syntheseverfahren für eine Verbindung mit der Fähigkeit einer n-n Wechselwirkung mit anderen Verbindungen der gleichen Art und / oder Verbindungen anderer Art zu schaffen. Auch sollen geeignete Verbindungen und eine Schichtenstruktur geschaffen werden, die effizient zur Herstellung von Halbleiterbauelementen verwendet werden können.

Diese Aufgabe wird erfindungsgemäß durch ein Syntheseverfahren mit den Merkmalen des Anspruchs 1 gelöst.

Dabei wird in einem ersten Syntheseschritt bei einem ω-Halogen-Alk-1-en (I), 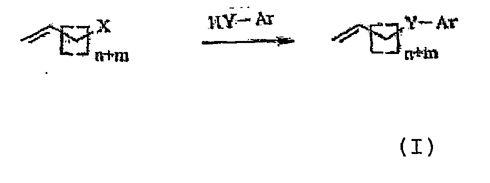 eine endständige nukleophile Substitution des Halogens mit einer Gruppe mit der Fähigkeit einer n-n Wechselwirkung, insbesondere einer Gruppe mit mindestens einer aromatischen Gruppe (Ar) durchgeführt. Anschließend wird das Produkt des ersten Syntheseschritts in einem zweiten Syntheseschritt hydrosilyiert.

Durch dieses zweischrittige Syntheseverfahren wird aufgrund der hohen Ausbeute und der leichten Reinigungsmöglichkeiten eine kostengünstige Herstellung von geeigneten Verbindungen ermöglicht.

Die erfindungsgemäßen Verbindungen gemäß Anspruch 12 sind gut für die Verwendung als dielelektrische Schicht mit einer stabilisierenden Kopfgruppe geeignet. Die Kopfgruppen üben untereinander Wechselwirkungen aus, so dass eine stabile Oberfläche einer molekularen Monolage geschaffen wird, die leicht weiter zu strukturieren ist.

Eine solche Monolage ist dann in einer erfindungsgemäßen Schichtstruktur eines Halbleiterbauelementes, insbesondere in einem organischen Feldeffekttransistor verwendbar.

Vorteilhafte Ausgestaltungen sind in den Unteransprüchen angegeben.

Die Erfindung wird nachfolgend unter Bezugnahme auf die Figuren der Zeichnungen an mehreren Ausführungsbeispielen näher erläutert. Es zeigen:
- Fig. 1: allgemeines Reaktionsschema der ersten beiden Syntheseverfahrensschritte;
- Fig. 2: aromatische Gruppen mit der Fähigkeit einer n-n Wechselwirkung;
- Fig. 3: allgemeines Reaktionsschema für eine Synthese eines ω-Halogen-Alk-1-ens;
- Fig. 4: Reaktionsschema für die Synthese von 18-Bromoctadec-1-en;
- Fig. 5: Strukturformel für 8-Bromoct-1-en;
- Fig. 6: Strukturformel für 18-Bromoctadec-1-en;
- Fig. 7: Reaktionsschema der Synthese von (18-Phenoxyoctadecly)trichlorsilan ;
- Fig. 8: Strukturformel für Octadec-17-enyloxybenzol ;
- Fig. 9: Strukturformel für (18-Phenoxyoctadecyl)trichlorsilan;
- Fig. 10: Reaktionsschema für die Synthese von [18-(1',1"-Biphenyl-4'-yloxy)octadecyl)]trichlorsilan;
- Fig. 11: Strukturformel für 4-Octadec-17"-enyloxy-1,1'-biphenyl;
- Fig. 12: Strukturformel für [18-(1',1"-Biphenyl-4'-yloxy)octadecyl)] trichlorsilan;
- Fig. 13: Reaktionsschema für die Synthese von (17-Thien-2'-ylheptadecyl)trichlorsilan (a) und (18-Thien-2'-yloctadecyl)trichlorsilan (b);
- Fig. 14: Strukturformel für 2-Heptadec-16'-enylthiophen;
- Fig. 15: Strukturformel für (17-Thien-2'-ylheptadecyl)trichlorsilan;
- Fig. 16: Strukturformel für 2-Octadec-17'-enylthiophen;
- Fig. 17: Strukturformel für (18-Thien-2'-yloctadecyl) trichlorsilan;
- Fig. 18: Reaktionsschema für die Synthese von 4-(18'-Trichlorsilyloctadecyloxy)benzonitril;
- Fig. 19: Strukturformel für 4-Octadec-17'-enyloxybenzonitril;
- Fig. 20: Strukturformel für 4-(18'-Trichlorsilyloctadecyloxy) benzonitril;
- Fig. 21: eine Strukturformel einer Ausführungsform der erfindungsgemäßen Verbindung;
- Fig. 22: eine Monolage zur Bildung einer Schichtstruktur mit einer Ausführungsform der erfindungsgemäßen Verbindung auf einem Substrat;
- Fig. 23: schematischer Aufbau eines organischen Feldeffekttransistors;

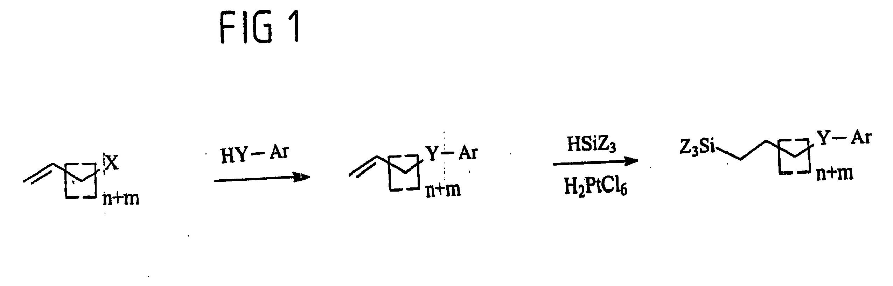

In Fig. 1 wird eine Ausführungsform des erfindungsgemäßen Syntheseverfahrens beschrieben.

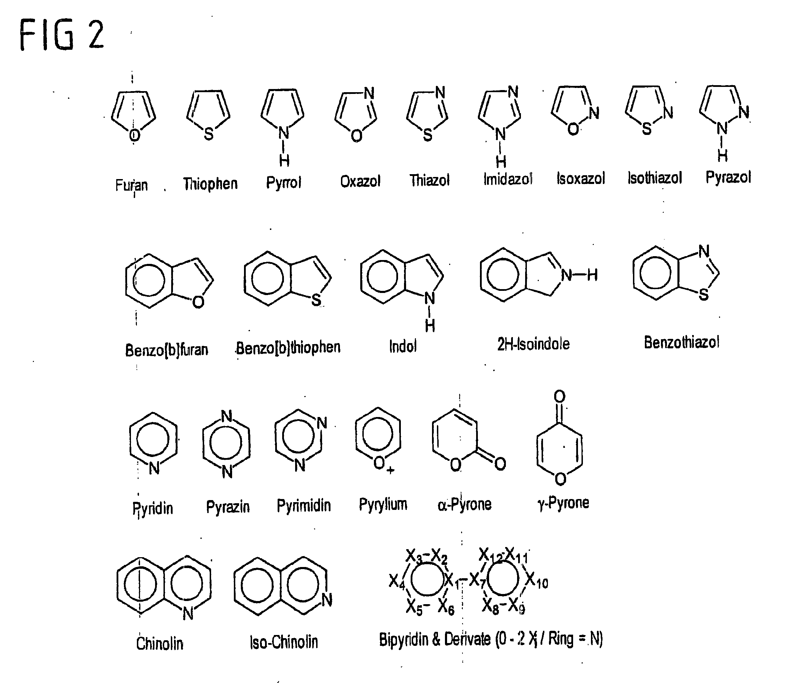

Edukt ist ein ω-Halogen-Alk-1-en (I). Am Ende der Kette, das der Doppelbindung entgegengesetzt ist, liegt ein substituiertes. Halogen X vor. Dieses ω-Halogen-Alk-1-en (I) wird in noch zu beschreibender Weise aus zwei kürzeren Ketten (Kettenlängen n, m) hergestellt (siehe Fig. 2). Im Beispiel der Fig. 1 ist n=6, m=10 und X=Cl, Br oder I.

Das Halogen X wird im ersten Syntheseschritt mit einer Gruppe, enthaltend eine aromatische Gruppe Ar mit der allgemeinen Formel

HY - Ar

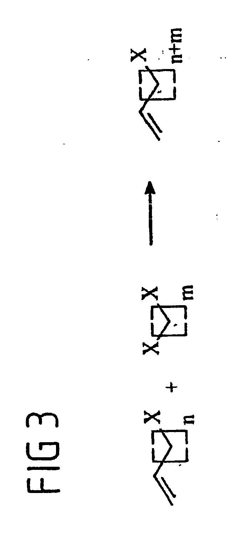

mit Y: O, S, Se oder -NH substituiert. Als aromatische Gruppen kann mindestens eine der Gruppen gemäß Fig. 3 verwendet werden. Auch ein Naphtalen, Anthracen, Naphtacen, Pentacen, Biphenyl, Terphenyl, Quaterphenyl und / oder Quinquephenyl sind verwendbar. Dabei kann eine aromatische Gruppe Ar oder auch ein Mehrringsystem aus gleichen oder unterschiedlichen Gruppen verwendet werden.

Nach dem ersten Syntheseschritt liegt ein Produkt vor, das eine aromatische Kopfgruppe aufweist, die die Fähigkeit einer n-n Wechselwirkung mit anderen Molekülen aufweist.

Dieses Produkt wird im zweiten Syntheseschritt einer Hydrosilyierung unterworfen. Dabei wird am Ende der Kette, das der Kopfgruppe entgegengesetzt ist, das Molekül silyiert. Im Beispiel der Fig. 1 wird HSiZ₃ mit Z: Cl oder Alkoxylgruppe verwendet. Die Reaktion erfolgt vorteilhafterweise säurekatalysiert, hier mit Hexachloroplatin (IV) säure (H₂PtCl₆).

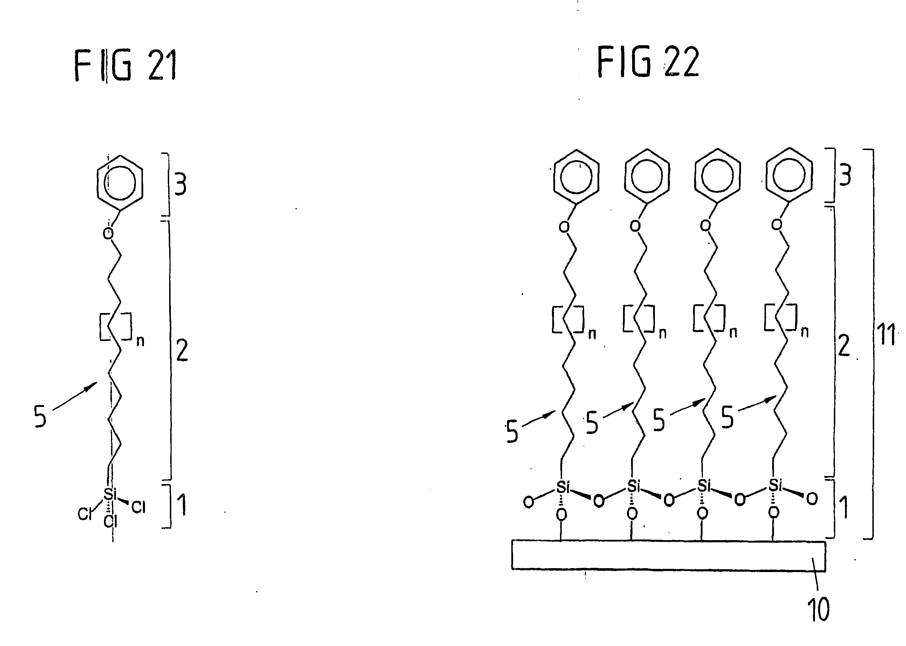

Das Produkt des zweiten Syntheseschrittes weist neben der aromatischen Kopfgruppe, eine Silan-Ankergruppe auf, die mit einem Substrat oder einer Schicht auf einem Substrat eine Bindung eingehen kann. Dies wird anhand von Fig. 21 und 22 näher erläutert.

In Fig. 2 sind aromatische Gruppen Ar mit der Fähigkeit einer n-n Wechselwirkung dargestellt. Es können auch andere aromatische Verbindung, insbesondere mindestens ein Naphtalen, Anthracen, Naphtacen, Pentacen, Biphenyl, Terphenyl, Quaterphenyl und / oder ein Quinquephenyl verwendet werden.

Auch sind Ketten mit jeweils unterschiedlichen aromatischen Ringsystemen in der Kette möglich. Über die Länge der kondensierten Ketten lassen sich die Eigenschaften gut einstellen. Dabei sind kleinere, meist nicht hochkondensierte Aromaten, die die im Wesentlichen einkristalline bzw. epitaktische zweidimensionale Struktur der Monolage 11 (siehe Fig. 22) nicht stören, besonders gut geeignet.

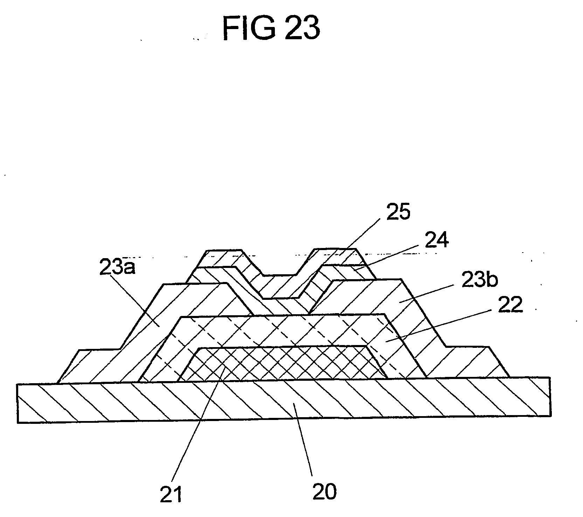

Mittels dieser Wechselwirkungen können Schichten ausgebildet werden, die für DielektriKa in organischen Feldeffekttransistoren gut geeignet sind (siehe Fig. 23).

Die π-π Wechselwirkung tritt bei den Monolagen 11 spontan ein und braucht nicht initiiert zu werden. Prinzipiell ist es möglich, auch innerhalb der SAM solche Gruppen zur Ausbildung einer π-π Wechselwirkung einzuführen, die dann allerdings nicht mehr als Kopfgruppen zu bezeichnen sind.

In Fig. 3 wird als eine Ausführungsform eine allgemeine Reaktion zur Herstellung eines ω-Halogen-Alk-1-en dargestellt, d.h. einer Vorreaktion zu den beiden oben genannten Syntheseschritten. Das ω-Halogen-Alk-1-en ist das Edukt für den ersten Syntheseschritt. Das Halogen X ist bevorzugt Cl, Br oder I; hier Br. Dabei kann n= 2 bis 12 sein; im Beispiel ist n=6. Die Kettenlänge des zweiten Reaktanden m kann zwischen 5 und 15 liegen; hier ist m = 10.

Im Folgenden werden Stufen von Ausführungsformen erfindungsgemäßen Synthese beschrieben.

### Beispiel 1.1: Darstellung von 18-Bromoctadec-1-en

Verbindungen mit Alkylketten und unterschiedlichen Substituenten in α und ω-Stellung sind nur bis zu einer Kettenlänge von 12 Kohlenstoffatomen kommerziell erhältlich. Für längerkettige Verbindungen sind ω-Bromalkene häufig verwendete Ausgangsprodukte, da eine Vielzahl einfacher Reaktionen es ermöglicht, selektiv eine der bei den funktionellen Gruppen umzuwandeln. Dies ist ein vorbereitender Schritt für die erfindungsgemäße Synthese, ein halogenisiertes 1-Alken dann weiter reagiert.

Heid stellt Bromheptadec-1-en aus der Grignardverbindung von 5-Brompent-1-en und einem Überschuss an 1,12- Dibromdodecan mit einer Lithium-Kupfer katalysierten Kupplungsreaktion in 66% Ausbeute dar und ermöglichte den Verzicht auf die bei älteren Vorschriften (S.R. Wassermann, Y.-T. Tao, G.M. Whitesides, Langmuir 1989, 5, 1074) nötige aufwändige mitteldruckchromatographische Reinigung. Überschüssiges Edukt und das aus einer zweifachen Reaktion entstandene Nebenprodukt Docosa-1,21-dien werden durch zweimalige Chromatographie abgetrennt.

Analog wurde 18-Bromoctadec-1-en aus 6-Bromhex-1-en synthetisiert, aufgrund einer Nebenreaktion mit nur 12 % Ausbeute (F. Effenberger, S. Heid, Synthesis 1995, 1126).

Im vorliegenden Beispiel konnte durch geschickte Wahl der Edukte auf eine chromatographische Reinigung, die bei der Darstellung von Mengen größer 10 g sehr aufwändig ist, ganz verzichtet werden. Die Grignardverbindung von 8-Bromoct-1-en wurde nach den von S. Heid (S.-Heid, Dissertation, Stuttgart, 1994, S. 197 ff.) ausgearbeiteten Bedingungen mit einem Überschuss an 1,10-Dibromdecan umgesetzt.

Die Nebenprodukte unterscheiden sich im Siedepunkt so deutlich vom Produkt, dass eine einfache Destillation über eine 20 cm Vigreuxkolonne ausreicht, um das Produkt analysenrein in 60 % Ausbeute zu isolieren.

8-Bromoct-1-en wurde unter gleichen Bedingungen aus Allylbromid und 1,5- Dibrompentan dargestellt und nach Destillation an einer 60 cm Spaltrohrkolonne in 60 % Ausbeute analysenrein isoliert.

Die Synthese von 8-Bromoct-1-e n wurde von Johnson und Mitarbeitern bereits mit einer Ausbeute von 33 % bezogen auf Allylmagnesiumbromid veröffentlicht (D.K. Johnson, J. Donohoe, J. Kang, Synth. Commun. 1994, 24, 1557).

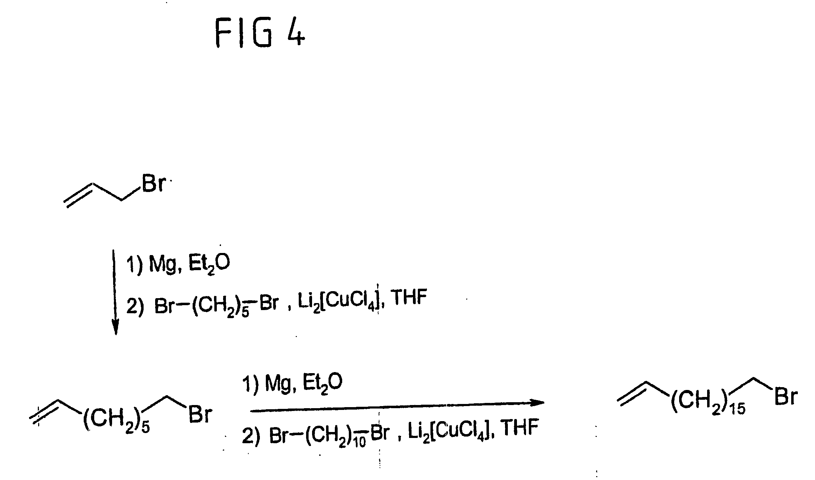

Die Syntheseschritte vom Allylbromid zum 18-Bromoctade-1-cen sind in Fig. 4 dargestellt und werden im Folgenden beschrieben.

### Darstellung von 8-Bromoct-1-en

| Ansatz: | | |
|---|---|---|
| Allylbromid: | 87 ml | 1,00 mol |
| | | |
| Magnesium: | 50,1 g | 2,06 mol |
| | | |
| 1,5-Dibrompentan: | 296 ml | 2,17 mol |
| | | |
| Li₂CuCl₄-Lösung: | 0,5 ml | 0,05 mmol |
| | | |
| Diethylether: | 660 ml | |
| | | |
| THF: | 200 ml | |

Grignard-Reaktion: In einem ausgeheizten Kolben mit Ar-Atmosphäre wird Magnesium in Ether vorgelegt. Über einen Tropftrichter wird Allylbromid (gelöst in Ether) so zugegeben, dass das Lösungsmittel schwach siedet. Anschließend wird die Lösung weitere 90 min bis zum Sieden erhitzt.

### Herstellung des Kupfer-Lithium-Katalysators:

1 mmol (134,5 mg) CuCl₂ und 2 mmol (84,8 mg) LiCl - beide zuvor über P₄O₁₀ im Ölpumpenvakuum getrocknet - werden in 10 ml- abs-. THF (Tetrahydrofuran) gelöst. Die tiefrote Lösung wird bis zum vollständigen Lösen des Feststoffs gerührt und im Kühlschrank gelagert.

Kreuzkupplung: In einem zweiten Kolben (ausgeheizt und unter Schutzgasatmosphäre) wird 1,5-Dibrompentan in THF vorgelegt und auf 0°C abgekühlt. Vor dem Überführen der Grignard-Verbindung mittels Teflonkanüle wird der Katalysator zugegeben. Unmittelbar nach Zugabe der Grignard-Verbindung findet ein Farbumschlag von rötlich über grün nach farblos statt. Nach erfolgter Zugabe wird die Reaktion auf Raumtemperatur gebracht und über Nacht gerührt.

Aufarbeitung: Nach Zugabe von Wasser wird mit 300 ml gesättigte Ammoniumchlorid-Lösung neutralisiert und die Phasen werden im Scheidetrichter separiert. Nach der Phasentrennung wird die organische Phase im Vakuum bei ca. 40°C bis 100 mbar eingeengt, in 300 ml Dichlormethan aufgenommen und zweimal mit 200 ml Wasser gewaschen. Die so erhaltene organische Phase wird über Magnesiumsulfat getrocknet und das Lösungsmittel im Vakuum entfernt.

Danach wird über eine 60-cm-Spaltrohrkolonne (Rücklaufverhältnis 20:1) fraktioniert destilliert. Neben reinem Produkt wird so auch reines 1,5-Dibrompentan zurückgewonnen.

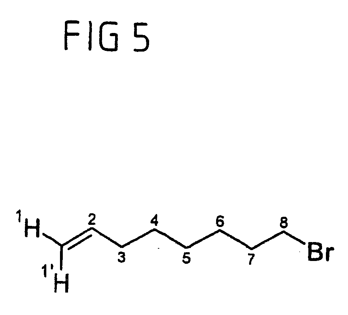

Ausbeute: 115 g (602 mmol) 60% 8-Bromoct-1-en (siehe Fig. 5); farblose Flüssigkeit

| | |
|---|---|
| Siedetemperatur: | 1,10-Undecadien: ca. 80°C |
| | 8-Bromoct-1-en: 94 -97°C |
| | 1,5-Dibrompentan: 110 -112°C |
| | jeweils bei 15 Torr |

| Analyse: C₈H₁₅Br (M: 191,11 g/mol) | | | | |
|---|---|---|---|---|
| | ber.: | C: 50,28 | H: 7,91 | Br: 41,81 |
| | gef.: | C: 50,03 | H: 7, 81 | Br: 41,97 |

¹H-NMR: (500 MHz, CDCl₃)
1,30 bis 1,47 (m; 6H; H4 bis H6); 1,86 (m; 2H; H7) ; 2,05 (m; 2H; H3) ; 3,41 (t; ³ J_{8,7} = 6,9 Hz; 2H; H8) ; 4,94 (m_{c}; 1H; H1) ; 5,00 (m_{c}; 1H; H1') ; 5, 80 (ddt; 1H; H2; ³J_{2,1}, = 17,0 Hz; ³J_{2,1} = 10,3 Hz; ³J_{2,3} = 6, 9 Hz)
¹³C-NRM : (126 MHz, CDCl₃)
28,4; 28,6; 29,1 (C4 bis C6); 33,2 (C7); 34,0 (C3); 34,4 (C8); 114,8 (C1) ; 139,3 (C2)

### Darstellung von 18-Bromoctadec-1-en

| Ansatz: | | |
|---|---|---|
| 8-Bromoct-1-en | 9,60 g | 50,2 mmol |
| Magnesium: | 2,00 g | 82,3 mmol |
| Et₂O: | 90 ml | |
| | | |
| 1,10-Dibromdecan: | 25,0 g | 111 mmol |
| | | |
| Li₂CuCl₄-Lösung: | 100 µl | |
| THF: | 50 ml | |

Grignard-Reaktion: In einem ausgeheizten Kolben mit Ar-Atmosphäre wird Magnesium in Ether vorgelegt. Über einen Tropftrichter wird 8-Bromoct-1-en (gelöst in Ether) so zugegeben, dass das Lösungsmittel schwach siedet, Anschließend wird die Lösung weitere 2 h bis zum Sieden erhitzt.

### Herstellung des Kupfer-Lithium-Katalysators:

1 mmol (134, 5 mg) CuCl₂ und 2 mmol (84, 8 mg) LiCl - beide zuvor über P₄O₁₀ im Ölpumpenvakuum getrocknet - werden in 10 ml abs. THF gelöst. Die tiefrote Lösung wird bis zum vollständigen Lösen des Feststoffs gerührt und im Kühlschrank gelagert.

Kreuzkupplung: In einem zweiten Kolben (ausgeheizt und unter Schutzgasatmosphäre) wird 1,10-Dibromdecan in THF vorgelegt und auf 0°C abgekühlt. Vor dem Überführen der Grignard-Verbindung mittels Teflonkanüle wird der Katalysator zugegeben. Unmittelbar nach Zugabe der Grignard-Verbindung findet ein Farbumschlag von rötlich über grün nach farblos statt. Nach erfolgter Zugabe wird die Reaktion auf Raumtemperatur gebracht und über Nacht gerührt.

Die Reaktion von 8-Bromoct-1-en und 1,10-Dibromdecan zu 18-Bromoctadec-1-en (Fig. 4) ist ein Beispiel für die allgemeine Reaktion zur Herstellung des ω-Halogen-Alk-1-en gemäß Fig. 3.

Aufarbeitung: Es wird soviel Wasser zugegeben, dass sich alles MgBr₂ auflöst. Nun werden die Phasen im Scheidetrichter separiert. Die organische Phase wird noch zweimal mit Wasser gewaschen, anschließend über MgSO₄ getrocknet und das Lösungsmittel im Vakuum entfernt. Das Produkt wird im Vakuum bei 0,04 Torr über eine Vigreux-Kolonne bei 132 - 137 °C fraktioniert destilliert.

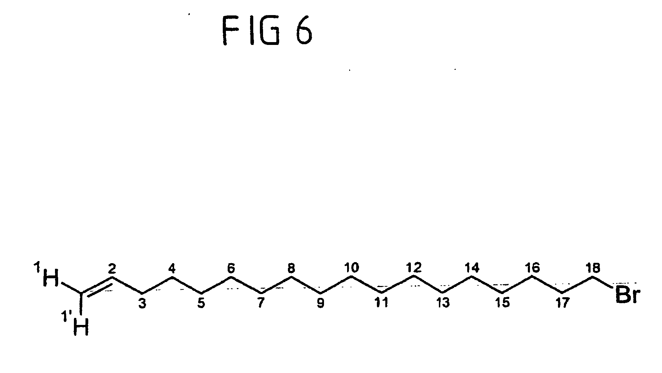

Ausbeute: 9,98 g (30,1 mmol) 60% 18-Bromoctadec-1-en (siehe Fig. 6); farblose Flüssigkeit

Siedetemperatur: 132 - 137°C bei 0,04 Torr

| Analyse: C₈H₁₅Br (M: 331,38 g/mol) | | | | |
|---|---|---|---|---|
| | ber.: | C: 65,24 | H: 10,65 | Br: 24,11 |
| | gef.: | C: 65,38 | H: 10,63 | Br: 24,04 |

¹H-NMR: (500 MHz, CDCl₃)
1,22 bis 1,43 (m; 22H; H4 bis H14); 1,85 (m; 2H; H17); 2,04 (m; 2H; H3) ; 3,40 (t; 2H; H18; ³J_{18,17} = 6,8 Hz) ; 4,93 (m_{c}; 1H; H1) ; 4,99 (m_{c}; 1H; H1'); 5,81 (ddt; 1H; H2; ³J_{2,1'}= 17,1 Hz; ³J_{2,1} = 10,3 Hz; ³J_{2,3} = 6,8 Hz)
¹³C-NMR: (126 MHz, CDCl₃)
28,2; 28,8; 29,0; 29,2; 29,5; 29,5; 29,6; 29,6; 29,7 (C4 bis C16); 32,9 (C17); 33,8 (C3) ; 34,0 (C18); 114,1 (C1) ; 139,2 (C2)

### Beispiel 1.2 Darstellung von (18-Phenoxyoctadecyl) trichlorsilan

Das im Beispiel 1.1 gewonnene 18-Bromoctadec-1-en wird nun weiter umgesetzt.

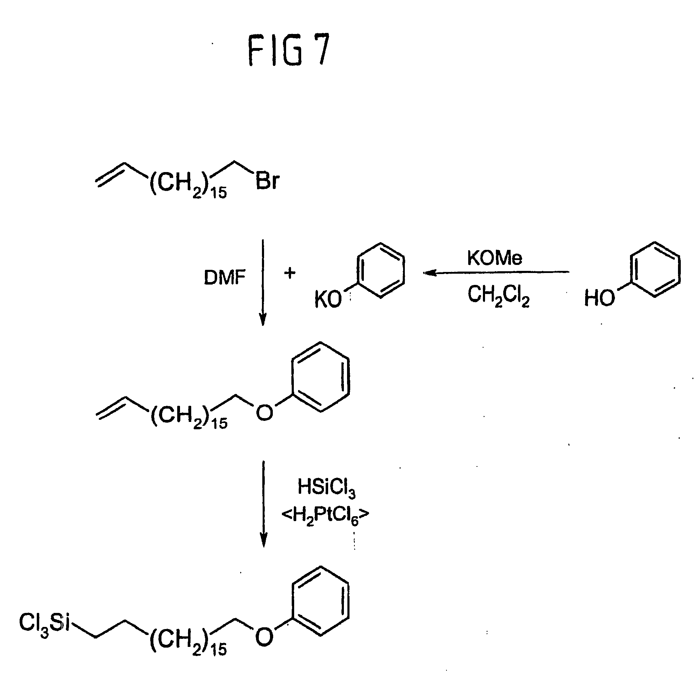

Die Folgenden Syntheseschritte sind Ausführungsbeispiele für das erfindungsgemäße Synthese verfahren, das aus zwei Syntheseschritten besteht. Ein Ausführungsbeispiel mit beiden Syntheseschritten wird in Fig. 7 dargestellt, wobei im Folgenden beide beschrieben werden.

Im ersten Syntheseschritt zur Synthese von Octadec-17-enyloxybenzol wird Kaliumphenolat, hergestellt aus Phenol und Kaliummethanolat, mit 18-Bromoctadecen (siehe Beispiel 1.1) in DMF (N,N-Dimthylformamid) umgesetzt. Nach Aufarbeitung und Säulenfiltration lag Octadec-17-enyloxybenzol analysenrein mit einer Ausbeute von 88% zur weiteren. Umsetzung vor.

Aus dem Alkenylphenylether wird dann im zweiten Syntheseschritt in einer Platin-katalysierten Hydrosilylierung das Trichlorsilan synthetisiert.

Dieses konnte, wie ¹H- und ¹³C-NMR sowie Massenspektroskopie belegen, nach abschließender Reinigung durch Kugelrohrdestillation mit 88% Ausbeute bezogen auf Octadec-17- enyloxybenzol -sauber erhalten werden.

Im Folgenden werden die beiden Syntheseschritte im Detail beschrieben.

### 1. Syntheseschritt: Darstellung von Octadec-17-enyloxybenzol

| | | | |
|---|---|---|---|
| Ansatz: | Phenol: | 4,26 g | 45,3 mmol |
| | KOMe: | 3,08 g | 43,9 mmol |
| | CH₂Cl₂: | 100 ml | |
| | 18-Bromoctadecen: | 10 g | 30,2 mmol |
| | DMF: | 100 ml | |

Darstellung von Kaliumphenolat: In einem Kolben wird Phenol in CH₂Cl₂ vorgelegt und mit KOMe versetzt. Das Reaktionsgemisch wird 15 min bei Raumtemperatur gerührt, anschließend wird das Lösungsmittel im Vakuum vollständig entfernt.

Etherkupplung: Zum Kaliumphenolat wird DMF und das entsprechende Alkylbromid gegeben und auf 150°C erhitzt. Nach 2 h wird die Reaktion auf Raumtemperatur gebracht, mit Wasser versetzt und mit verdünnter HCl neutralisiert.

Aufarbeitung: Im Scheidetrichter wird die wässrige DMF-Phase mit Ether mehrmals extrahiert. Die organische Phase wird mit Wasser DMF-frei gewaschen und über MgSO₄ getrocknet. Nach Entfernen des Lösungsmittels und Reinigung über Kieselgel mit PE/CH₂Cl₂ (1:1) als Laufmittel wird ein farbloser Feststoff erhalten.

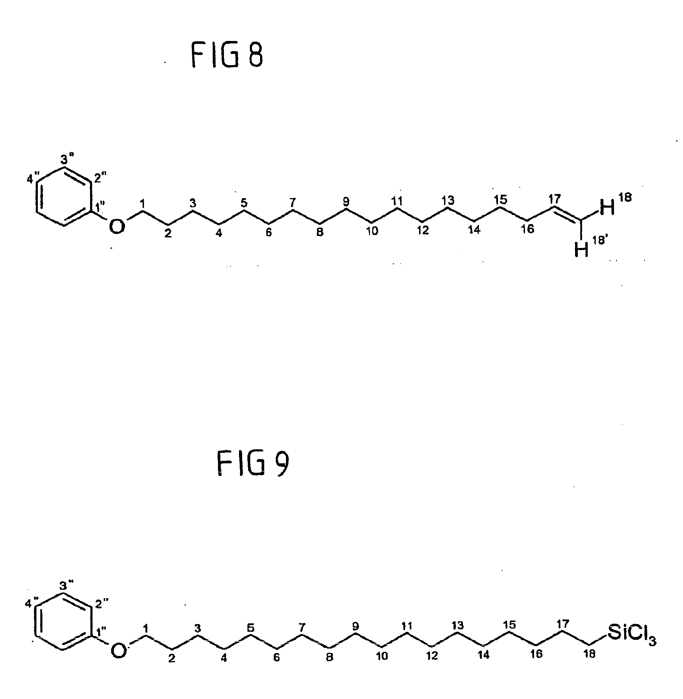

Ausbeute: 9,18 g (26,6 mmol) 88% Octadec-17-enyloxybenzol (siehe Fig. 8); farbloser Feststoff
Schmelztemperatur: 44 - 45°C
DC (PE/CH₂Cl₂ = 1 :1) : R_{f} = 0,65

| Analyse: C₂₄H₄₀O (M: 344,58 g/mol) | | | | |
|---|---|---|---|---|
| | ber.: | C: 83,56 | H: 11,70 | O: 4,64 |
| | gef.: | C: 83,66 | H: 11, 79 | O: - |

¹H-NMR: (500 MHz, CDCl₃)
1,22 bis 1,39 (m; 24H; H4 bis H15); 1,44 (m; 2H; H3); 1,77 (m; 2H; H2) ; 2,04 (m; 2H; H16) ; 3,95 (t; 2H; H1; ³J_{1,2} = 6,6 Hz) ; 4, 9:3 (m_{c}; 1H; H18); 4,99 (m_{c}; 1H; H18') ; 5,81 (ddt; 1H; H17; ³J_{17,18'} = 17,0 Hz; ³J_{17,18} = 10, 2 Hz; ³J_{17,16} = 6,6 Hz) ; 6,90 (m; 3H; H4" + H2"); 7,27 (m; 2H; H3")
¹³C-NMR: (126 MHz, CDCl₃)
26,0; 29,0; 29,2; 29,3; 29,4; 29,5; 29,5; 29,5; 29,5; 29,7 (C2 bis C15) ; 33,8 (C16) ; 67,9 (C1) : 114,1 (C18) ; 114,5 (C2") ; 120,4 (C4") ; 129,4 (C3") ; 139,3 (C17) ; 159,1 (C1")

### 2. Syntheseschritt: Darstellung von (18-Phenoxyoctadecyl)trichlorsilan

| | | | |
|---|---|---|---|
| Ansatz: | Octadec-17-enyloxybenzol: | 3 g | 8,71 mmol |
| | Trichlorsilan: | 8,8 ml | 87,1 mmol |
| | Hexachloroplatinsäure-Lösung: | | 10 Tropfen |

In einem ausgeheizten Zweihalskolben mit Rückflusskühler /Gasableitungsrohr mit Hahn/Argonballon und Gummiseptum wird Octadec-17-enyloxybenzol vorgelegt. Mit einer Spritze wird Trichlorsilan und die Katalysatorlösung zugegeben und über Nacht bei Raumtemperatur gerührt.

Nach dem Entfernen des überschüssigen Trichlorsilans im Wasserstrahlvakuum wird der Rückstand im Ölpumpenvakuum im Kugelrohr destilliert.

### Herstellung der Katalysatorlösung

164 mg H₂PtCl₆ aq. werden in 10 ml abs. Isopropanol gelöst. Die Lösung wird bis zum vollständigen Lösen des Feststoffs gerührt und im Kühlschrank gelagert.
Ausbeute: 3,66 g (7,63 mmol) 88%
(18-Phenoxyoctadecyl)trichlorsilan (siehe Fig. 9); farbloser Feststoff
Schmelztemperatur: 34°C
Siedetemperatur: 185 - 195°C bei 1 x 10⁻³ Torr

| MS (EI 70 eV) C₂₄H₄₁Cl₃OSi | | |
|---|---|---|
| | ber.: | 478,1992 |
| | gef . : | 478,1991 |

¹H-NMR: (250 MHz, CDCl₃)
1,26 bis 1,42 (m; 30H; H3 bis H17), 1,57 (m; 2H; H18), 1,78 (m; 2H; H2); 3,95 (t; 2H; H1; ³J_{1,2} = 6,6 Hz); 6,92 (m; 3H; H4" + H2"); 7,27 (m; 2H; H3")
¹³C-NMR: (63 MHz, CDCl3)
22, 2 (C18); 24,3 (C17); 29,1; 29,0; 29,3; 29,4; 29,4; 29,6; 29, 7 (C2 bis C15); 31,8 (C16); 67, 8 (C1); 114,4 (C2"); 120,4 (C4"); 129,4 (C3"); 159,1 (C1")

Das Produkt ist eine Verbindung, das bei der Herstellung von Monolagen bei der Herstellung von organischen Halbleiterelementen verwendet werden kann. Dies wird in den Fig. 22 und 23 beschrieben.

### Beispiel 2: Darstellung von

### [18- (1',1''-Biphenyl-4'-yloxy)octadecyl]trichlorsilan

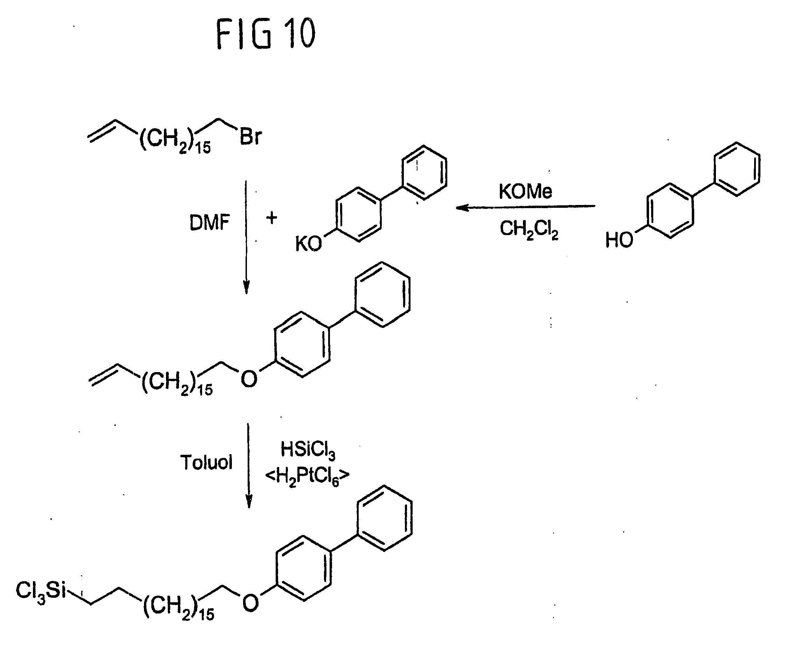

Diese Ausführungsform des erfindungsgemäßen Syntheseverfahrens erfolgt analog zur Synthese von (18-Phenoxyoctadecyl)trichlorsilan (Beispiel 1.2) ausgehend von 18-Bromoctadec-1-en in zwei Syntheseschritten (siehe Fig. 10) .

Dieses wird im ersten Syntheseschritt in DMF mit Kaliumbiphenyl-4-olat, hergestellt aus Biphenyl-4-ol und Kaliummethylat, zur Reaktion gebracht.

Das Zwischenprodukt 4-Octadec-17"-enyloxy-1,1'-biphenylkonnte nach Umkristallisieren aus Dichlormethan mit 79% Ausbeute analysenrein erhalten werden.

Im zweiten Syntheseschritt wird der als Zwischenprodukt entstandene Alkenylphenylether in einer Platin-katalysierten Hydrosilylierung zu [18-(1',1"-Biphenyl-4'-yloxy)octadecyl]trichlorsilan umgesetzt.

Da sich das 4-Octadec-17"-enyloxy-1,1'-biphenyl schlecht in Trichlorsilan löst, wurde Toluol als Co-Lösungsmittel zugegeben. Nach abschließender Destillation konnte das saubere Trichlorsilan mit 88% Ausbeute erhalten werden. Dies konnte durch Massenspektroskopie sowie ¹H- und ¹³C-NMR-Spektroskopie belegt werden. Im Folgenden werden die Syntheseschritte im Einzelnen beschrieben.

### 1. Syntheseschritt: Synthese von 4-Octadec-17"-enyloxy-1, 1'-biphenyl

| | | | |
|---|---|---|---|
| Ansatz: | 4-Hydroxybiphenyl: | 10,3 g | 60,4 mmol |
| | KOMe: | 4,43 g | 63,2 mmol |
| | CH₂Cl₂ ; | 180 ml | |
| | 18-Bromoctadecen | 15,8 g | 47,5 mmol |
| | DMF: | 80 ml | |

Darstellung von Kaliumphenolat: In einem Kolben wird 4-Hydroxybiphenyl in CH₂Cl₂ vorgelegt und mit KOMe versetzt. Das Reaktionsgemisch wird 15 min bei Raumtemperatur gerührt, anschließend wird das Lösungsmittel im Vakuum vollständig entfernt.

Etherkupplung: Zum Kaliumphenolat wird DMF und 18-Bromoctadec-1-en gegeben und auf bei 110°C erhitzt. Nach 2 h wird die Reaktion auf Raumtemperatur gebracht, mit Wasser versetzt und mit verdünnter HCl neutralisiert.

Aufarbeitung: Im Scheidetrichter wird die wässrige DMF-Phase dreimal mit heißem Dichlormethan extrahiert. Die organische Phase wird zweimal mit Wasser DMF-frei gewaschen und über MgSO₄ getrocknet. Nach Entfernen des Lösungsmittels wird der erhaltenen Feststoff dreimal aus Dichlormethan umkristallisiert.

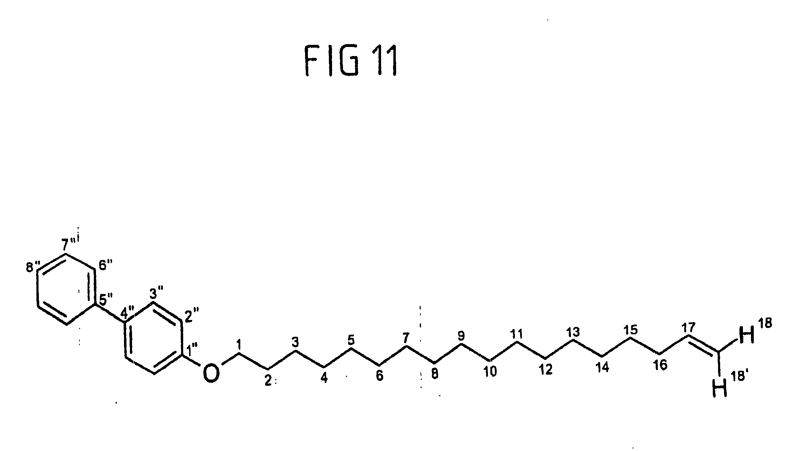

Ausbeute: 15,8 g (37,5 mmol) 79% 4-Octadec-17"-enyloxy-1,1'-biphenyl (siehe Fig. 11) ; farbloser Feststoff
Schmelztemperatur: 86°C

| Analyse: C₂₄H₄₀O (M: 420,68 g/mol) | | | | |
|---|---|---|---|---|
| | ber.: | C: 85,65 | H: 10,54 | O: 3,80 |
| | gef.: | C: 85,78 | H: 10,66 | O:- |

¹H-NMR: (500 MHz, CDCl3)
1,26 bis 1,39 (m; 24H; H4 bis H15) ; 1,47 (m; 2H; H3) ; 1,80 (m; 2H; H2); 2,04 (m; 2H; H16) ; 3, 99 (t; 2H; H1; ³J₁,₂ = 6,6 Hz) ; 4,92 (m_{c}; 1H; H18) ; 4,99 (m_{c}; 1H; H18'); 5, 81 (ddt; 1H; H17; ³J_{17,18'}= 17,0 Hz; ³J_{17,18} = 10,3 Hz; J_{17,16} = 6,7 Hz); 6,96 (m; 2H; H2") ; 7,29 (m; 1H; H8"); 7,41 (m; 2H; H7"); 7,51 (m; 2H; H3"); 7,54 (m; 2H; H6")
¹³C-NMR: (126 MHz, CDCl3)
26,1; 29,0; 29,2; 29,3; 29,4; 29,5; 29,6; 29,6; 29,6; 29,7 (C2 bis C15); 33,8 (C16); 68,1 (C1); 114,1 (C18); 114,8 (C2"); 126,6 (C8"); 126,7 (C6"); 128,1 (C3"); 128,7 (C7"); 133,5 (C4"); 139,3 (C17); 140,9 (CS"); 158,7 (C1")

### 2. Syntheseschritt: Darstellung von [18-(1',1''-Biphenyl-4'-yloxy)octadecyl]trichlorsilan

| Ansatz: | | |
|---|---|---|
| 4-Octadec-17''-enyloxy-1,1'-biphenyl: | 6 g | 14,26 mmol |
| Trichlorsilan: | 8,3 ml | 82,23 mmol |
| Hexachloroplatinsäure-Lösung: | 100 µl | |
| Toluol: | 30 ml | |

In einem ausgeheizten Zweihalskolben mit Rückflusskühler /Gasableitungsrohr mit Hahn/Argonballon und Gummiseptum wird das Olefin vorgelegt. Mit einer Spritze wird Trichlorsilan und die Katalysatorlösung zugegeben. Da das Edukt 4-Octadec-17"-enyloxy-1,1'-biphenyl sich schlecht in Trichlorsilan löst, werden zusätzlich 30 ml abs. Toluol als Co-Lösungsmittel zugefügt. Dies wird über Nacht bei Raumtemperatur gerührt.

Nach dem Entfernen des überschüssigen Trichlorsilans und des Toluols im Wasserstrahlvakuum wird der Rückstand im Ölpumpenvakuum über eine Vigreux-Kolonne destilliert.

### Herstellung der Katalysatorlösung:

164 mg H₂PtCl₆ aq. werden in 10 ml abs. Isopropanol gelöst. Die Lösung wird bis zum vollständigen Lösen des Feststoffs gerührt und im Kühlschrank gelagert.

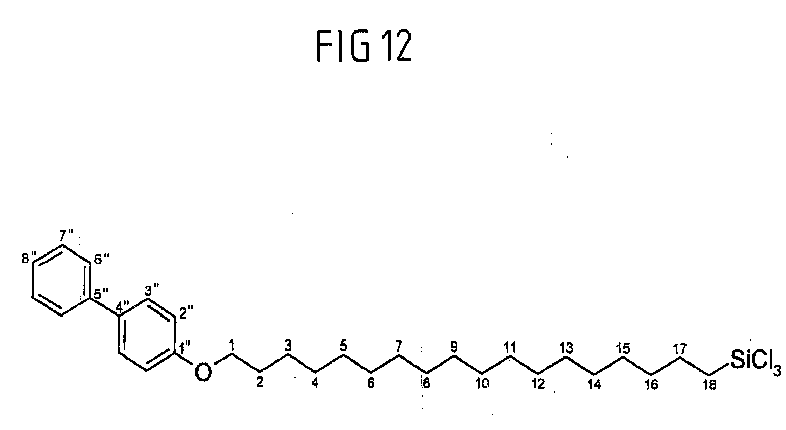

Ausbeute: 7, 01 g (12,6 mmol) 88% [18-(1',1''-Biphenyl-4' - yloxy)octadecyl]trichlorsilan (siehe Fig. 12); farbloser Feststoff
Siedetemperatur: 249 -263°C bei 3 x 10⁻⁵ mbar
Schmelztemperatur: 115 °C

| MS: (EI positiv-Ion) C₃₀H₄₅Cl₃OSi | | |
|---|---|---|
| | ber.: | 554,2305 |
| | gef.: | 554,2296 |

¹H-NMR: (500 MHz, CDCl3)
1,26 bis 1,43 (m; 28H; H4 bis H17), 1,47 (m; 2H; H3); 1,58 (m; 2H; H18), 1, 80 (m; 2H; H2); 3,99 (t; 2H; H1'; ³J_{1,2} = 6,5 Hz) ; 6,97 (m; 2H; H2") ; 7,30 (m; 1H; H8") ; 7,41 (m; 2H; H7") ; 7,51 (m; 2H; H3") ; 7,55 (m; 2H; H6")
¹³C -NMR: (126 MHz, CDCl₃)
22,2 (C18); 24,3 (C17); 26,1; 29,0; 29,3; 29,3; 29,4; 29,6; 29,7 (C2 bis C15); 31,8 (C16); 68,1 (C1) ; 114,7 (C2"); 126,6 (C8"); 126,7 (C6"); 128,1 (C3"); 128,7 (C7"); 133,5 (C4"); 140,9 (C5"); 158,7 (C1")

### Beispiel 3: Darstellung von

### (17- Thien-2' -ylheptadecyl) trichlorsilan (a) und (18- Thien-2' -yloctadecyl) trichlorsilan (b)

Die Darstellung von 2-Heptadec-16'-enylthiophen und 2-Octadec-17'-enylthiophen erfolgt im ersten Syntheseschritt durch Umsetzung des jeweilige Bromalkens bzw. mit 2-Thienyllithium, das vorher aus Thiophen und n-BuLi hergestellt wurde. Um eine aufwändige Reinigung zu vermeiden, wird 2-Thienyllithium in großem Überschuss bei langen Reaktionszeiten und milden Bedingungen eingesetzt.

Nach Säulenchromatographie konnten die Alkenylthiophene jeweils in 84% Ausbeute für 2-Heptadec-16'-enylthiophen und in 90% Ausbeute für 2-Octadec-17'-enylthiophen erhalten werden.

Ausgehend von den beiden Alkenthiophenen 2-Heptadec-16'-enylthiophen und 2-Octadec-17'-enylthiophen wurde im zweiten Syntheseschritt jeweils in einer Hydrosilylierung mit Trichlorsilan und Hexachloroplatinsäure als Katalysator das entsprechende Trichlorsilan (17- Thien-2'-ylheptadecyl)trichlorsilan bzw. (18-Thien-2'-yloctadecyl) trichlorsilan dargestellt.

Nach Destillation konnte (17-Thien-2'-ylheptadecyl)trichlorsilan (a) mit 84% Ausbeute und (18-Thien-2'-yloctadecyl)trichlorsilan (b) mit 83% Ausbeute, bezogen auf das jeweilige Olefin, als farblose Flüssigkeit isoliert werden.

Anhand von Massenspektrometrie, ¹H- und ¹³C-NMR-Spektren zeigte sich, dass es sich um die gewünschten Verbindungen handelte.

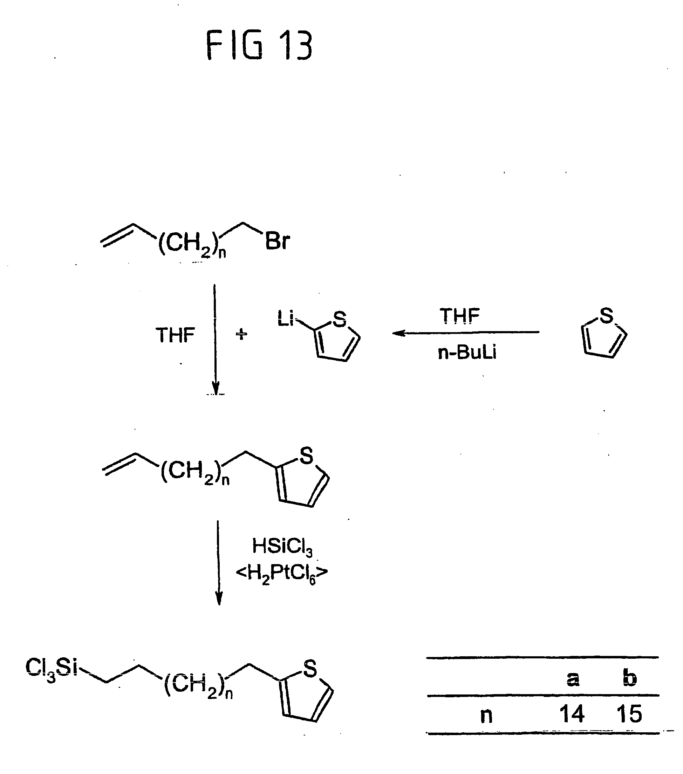

In Fig. 13 sind die beiden Syntheseschritte zusammen dargestellt.

### 1. Syntheseschritt: Darstellung von 2-Heptadec-16'-enylthiophen (für Fall a))

| Ansatz: | | |
|---|---|---|
| Thiophen: | 10,6 ml | 119 mmol |
| n-BuLi: | 40 ml | 65,6 mmol |
| THF: | 100 ml | |
| 17 -Bromheptadecen : | 5 g | 15,8 mmol |

In einem ausgeheizten Zweihalskolben mit Gummiseptum werden unter Schutzgasatmosphäre 40 ml n-BuLi-Lösung (15%ig in Hexan) vorgelegt und auf -10°C abgekühlt, bevor 100 ml THF zugegeben werden. Unter Kühlung werden innerhalb 10 min 10g Thiophen mit einer Spritze zugegeben, wobei sich eine Gelbfärbung einstellt. Nach der Zugabe des gesamten Thiophens wird auf Raumtemperatur erwärmt und es werden 5 g 17-Bromheptadecen auf einmal zugegeben. Anschließend wird bei derselben Temperatur über Nacht gerührt.

Zur Aufarbeitung wird mit Eiswasser hydrolysiert, und nach dem Abtrennen der organischen Phase die wässrige Phase dreimal mit Diethylether extrahiert. Die vereinigten organischen Phasen werden über Natriumsulfat getrocknet. Das Entfernen des Lösungsmittels am Rotationsverdampfer ergibt ein gelbes Öl, das durch Chromatographie an Kieselgel mit n-Hexan als Laufmittel gereinigt wird.

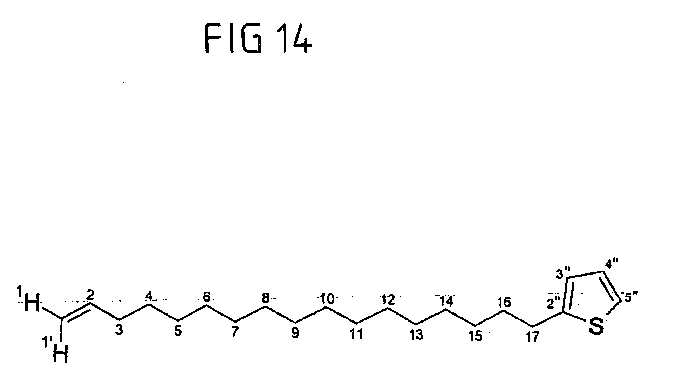

Ausbeute: 4,25 g (13,3 mmol) 84% 2-Heptadec-16'-enylthiophen (siehe Fig. 14); farbloses Öl;
¹H-NMR: (250 MHz, CDCl3)
1,26 bis 1,31 (m; 24H; H4 bis H15); 1,67 (m; 2H; H16); 2,03 (m; 2H; H3); 2,79 (t; 2H; H17; ³J_{17,16} = 7,6); 4,90 bis 5,03 (m; 2H; H1 + H1'); 5,81 (ddt; 1H; H2; ³J_{2,1'} = 17, 1; ³J_{2,1} = 10,2; ³J_{2,3} = 6,7) ; 6,77 (m; 1H; H3"); 6,90 (dd; 1H; H4"; ³J_{4",5"} = 5,1; ³J_{4",3"} = 3,4); 7,09 (dd; 1H; H5"; ³J_{5",4"} = 5,1; ⁴J_{5",3"} = 1,1)
¹³C-NMR: (63 MHz, CDCl3)
29,0; 29,2; 29,4; 29,6; 29,7; 29,9 (C2 bis C16); 31,8 (C17); 33,9 (C3); 114, 1 (C1); 122,7 (C5"); 123,9 (C3"); 126,6 (C4") ; 139,3 (C2); 145,8 (C2")

### 2. Syntheseschritt: Darstellung von (17- Thien-2'-ylheptadecyl)trichlorsilan (Fall a))

| Ansatz: | | |
|---|---|---|
| 2-Heptadec-16'-enylthiophen : | 2,55 g | 7,95 mmol |
| Trichlorsilan: | 8,0 ml | 79,5 mmol |
| Hexachloroplatinsäure-Lösung: | 10 Tropfen | |

In einem ausgeheizten Zweihalskolben mit Rückflusskühler /Gasableitungsrohr mit Hahn/Argonballon und Gummiseptum wird 2-Heptadec-16'-enylthiophen vorgelegt. Mit einer Spritze werden Trichlorsilan und die Katalysatorlösung zugegeben und es wird über Nacht bei Raumtemperatur gerührt.

Nach dem Entfernen des überschüssigen Trichlorsilans im Wasserstrahlvakuum wird der Rückstand im Ölpumpenvakuum über eine Vigreux-Kolonne destilliert.

### Herstellung der Katalysatorlösung:

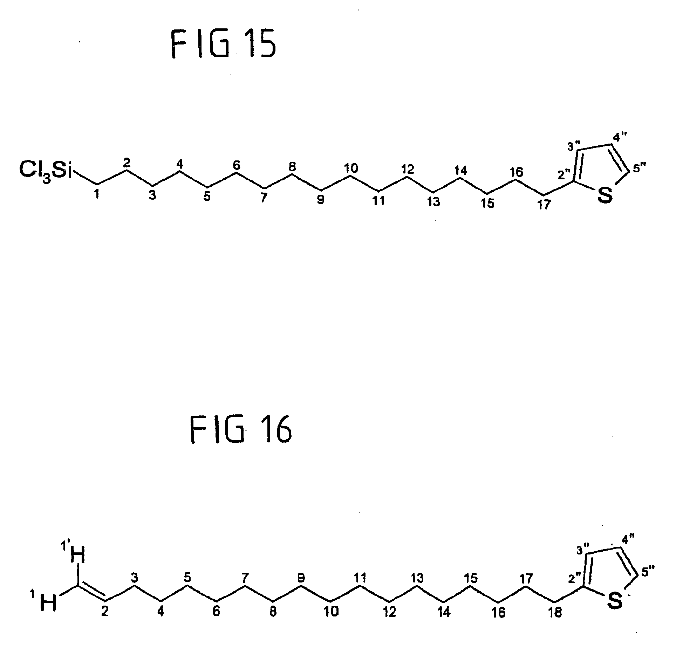

164 mg H₂PtCl₆ aq. werden in 10 ml abs. Isopropanol gelöst. Die Lösung wird bis zum vollständigen Lösen des Feststoffs gerührt und im Kühlschrank gelagert.
Ausbeute: 3,03 g (6,64 mmol) 84% (17-Thien-2'-ylheptadecyl)trichlorsilan (siehe Fig. 15); farbloses Öl
Siedetemperatur: 155 - 177 °C bei 1 x 10⁻³ Torr

| MS: (EI 70 eV) C₂₁H₃₇Cl3SSi | | |
|---|---|---|
| | ber.: | 454,1450 |
| | gef.: | 454,1450 |

¹H-NMR: (500 MHz, CDCl3)
1,26 bis 1,43 (m; 28H; H2 bis H15), 1,57 (m; 2H; H1), 1,67 (m; 2H; H16); 2,81 (t; 2H; H17; ³J_{17,16} = 7,7); 6,77 (dd, 1H, H3''; ³J_{3",4"} = 3,1; ⁴J_{3",5"} = 1,0); 6,90 (dd; 1H; H4"; ³J_{4",5"} = 5,1; ³J_{5",3"} = 3,3); 7,09 (dd; 1H; H5''; ³J_{5",4"} = 5,1; ⁴J_{5",3"}=1,0)
¹³C-NMR : (125-MHz, CDCl3)
22,3 (C1); 24,3 (C2); 29,0; 29,1; 29,4; 29,6; 29,6; 29.6; 29,7; 29,9 (C3 bis C16); 31,8 (C17); 122,7 (C5") 123,9 (C3"); 126,6 (C4"); 145,9 (C2")
Infrarotspektroskopie (CCl₄):
ν(Si-Cl) = 589; m; δₛ (CH₂) = 1465; w; (CH₂ = 2854; s; νₐₛ (CH₂) = 2928; vs

### 1. Syntheseschritt: Darstellung von 2-Octadec-17'-enylthiophen (Fall b))

| Ansatz: | | |
|---|---|---|
| Thiophen: | 24,8 ml | 259 mmol |
| n-BuLi: | 93,5 ml | 65,6 mmol |
| THF: | 240 ml | |
| 17 -Bromoctadec-1-en: | 12,1 g | 36,6 mmol |

In einem ausgeheizten Zweihalskolben mit Gummiseptum werden unter Schutzgasatmosphäre 93,5 ml n-BuLi-Lösung (15%ig in Hexan) vorgelegt und auf -10°C abgekühlt, bevor 240 ml THF zugegeben werden. Unter Kühlung werden innerhalb 10 min 24,8 ml Thiophen mit einer Spritze zugegeben, wobei sich eine Gelbfärbung einstellt. Nach der Zugabe des gesamten Thiophens lässt man auf Raumtemperatur erwärmen und gibt 12,1 g 18-Bromoctadec-1-en auf einmal zu. Anschließend wird bei derselben Temperatur über Nacht gerührt.

Zur Aufarbeitung wird mit Eiswasser hydrolysiert, und nach dem Abtrennen der organischen Phase die wässrige Phase dreimal mit Diethylether extrahiert. Die vereinigten organischen Phasen werden über Natriumsulfat getrocknet. Das Entfernen des Lösungsmittels am Rotationsverdampfer ergibt ein gelbes Öl, das durch Chromatographie an Kieselgel mit n-Hexan als Laufmittel gereinigt wird.

Ausbeute: 11,1 g (33,1 mmol) 90% 2-Octadec-17'-enylthiophen (siehe Fig. 16); farbloses Öl

| Analyse: C₂₄H₄₀S (M: 334,60 g/mol) | | | | |
|---|---|---|---|---|
| | ber.: | C: 78,97 | H: 11,45 | S: 9,58 |
| | gef.: | C: 79,26 | H: 11,58 | S: 9,39 |

¹H-NMR : (500 MHz , CDCl₃)
1,21 bis 1,43 (m; 26H; H4 bis H16), 1,67 (m; 2H; H17), 2,04 (m; 2H; H3), 2,81 (t; 2H; H18; ³J_{18,17} = 7,7), 4,92 (m_{c}; 1H; H1) ; 4,99 (m_{c}; 1H; H1'); 5, 81 (ddt; 1H; H2; ³J_{2.1},= 17,1; ³J_{2,1} = 10, 2; ³J_{2,3} 6,7); 6,77 (dd; 1H; H3''; ³J_{3",4"} = 3,4; ⁴J_{3",5"} = 0,8); 6,90 (dd, 1H, H4; ³J_{4",5"} = 5,1, ³J_{4",3"} =3,4) ; 7,09 (dd, 1H, H5''; ³J_{5",4"} = 5,1; ⁴_{J5",3"} = 0,8)
¹³C -NMR: (126 MHz, CDCl₃)
29,0; 29,1; 29,2; 29,4; 29,5; 29,6; 26,6 29,7; 29,7; 29,9 (C2 bis C17) ; 31,8 (C18) ; 33,8 (C3) ; 114,1 (C1) ; 122,7 (C5") ; 123,9 (C3") ; 126,6 (C4") ; 139,3 (C2) ; 145,9 (C2")

### 2. Syntheseschritt: Darstellung von (18- Thien-2'-yloctadecyl)trichlorsilan (Fall b))

| Ansatz: | | |
|---|---|---|
| 2-Octadec-17'-enylthiophen: | 7 g | 20,9 mmol |
| Trichlorsilan: | 21,1 ml | 209 mmol |
| Hexachloroplatinsäure-Lösung: | 10 Tropfen | |

In einem ausgeheizten Zweihalskolben mit Rückflusskühler /Gasableitungsrohr mit Hahn/Argonballon und Gummiseptum wird 2-Octadec-17'-enylthiophen vorgelegt. Mit einer Spritze wird Trichlorsilan und die Katalysatorlösung zugegeben und es wird über Nacht bei Raumtemperatur gerührt.

Nach dem Entfernen des überschüssigen Trichlorsilans im Wasserstrahlvakuum wird der Rückstand im Ölpumpenvakuum über eine Vigreux-Kolonne destilliert.

### Herstellung der Katalysatorlösung:

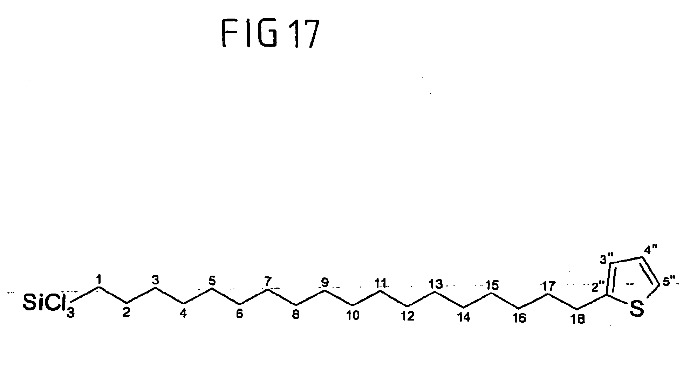

164 mg H₂PtCl₆ aq. werden in 10 ml abs. Isopropanol gelöst. Die Lösung wird bis zum vollständigen Lösen des Feststoffs gerührt und im Kühlschrank gelagert.
Ausbeute: 8,13 g (17,3 mmol) 83% (18- Thien-2'-yloctadecyl) trichlorsilan (siehe Fig. 17) ; farbloses Öl
Siedetemperatur: 183 -211°C bei 5 x 10⁻⁴ Torr

| MS: (EI 70 eV) C₂₂H₃₉Cl₃SSi | | |
|---|---|---|
| | ber.: | 468,1607 |
| | gef.: | 468,1607 |

¹H-NMR: (500 MHz, CDCl₃)
1,26 bis 1,44 (m; 30H; H2 bis H16), 1,57 (m; 2H; H1), 1,67 (m; 2H; H17); 2,81 (t; 2H; H18; ³J_{17,16} = 7,7) ; 6,77 (dd; 1H; H3"; ³J_{3",4"} = 3,3; ⁴J_{3",5"} = 0,9); 6,90 (dd; 1H; H4" ; ³J_{4",5"} = 5,1; ³J_{4",3"} = 3,4); 7,09 (dd; 1H; H5" ; ³J_{5",4"} = 5,1; ⁴J_{5"3"} = 0,9)
¹³C-NMR: (125 MHz, CDCl₃)
22,7 (C1) ; 24,7 (C2); 29,4; 29, 6; 29, 8; 30, 0; 30, 0; 30,0; 30, 0; 30,3 (C3 bis C17); 32,2 (C18) ; 123,1 (C5") ; 123,3 (C3"); 127,0 (C4"); 146,3 (C2")

### Beispiel 4: Synthese von 4-(18'-Trichlorsilyloctadecyloxy)benzonitril

Um die Eigenschaften eines auf der Monoschicht 11 entstehenden Amins möglichst wenig zu beeinflussen, wird als Edukt 4-Hydroxybenzonitril gewählt. Dieses wird im ersten Syntheseschritt in einer Williamsonschen Ethersynthese mit 18-Bromoctadec-1-en in DMF umgesetzt. Das entstandene 4-Octadec-17'-enyloxybenzonitril kann nach chromatographischer Reinigung in 80%iger Ausbeute analysenrein erhalten werden.

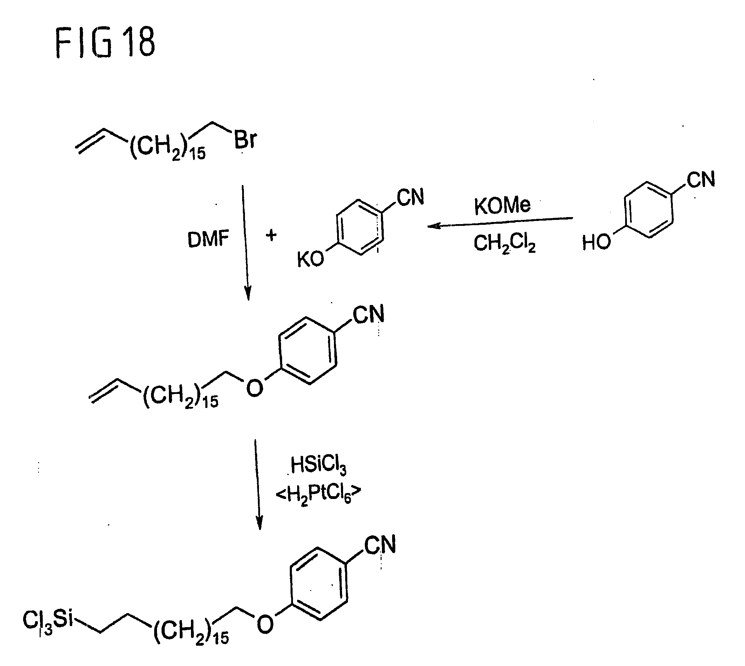

Im zweiten Syntheseschritt wird 4-0ctadec-17'-enyloxybenzonitril in einer Platin-katalysierten Reaktion mit Trichlorsilan hydrosilyliert. Nach Destillation fiel es in guter Ausbeute (82%) als farbloser Feststoff an. Die Charakterisierung von 4-(18'-Trichlorsilyloctadecyloxy)benzonitril erfolgte mit ¹H- und ¹³C-NMR sowie Massenspektrometrie. Die beiden Syntheseschritte sind zusammen in Fig. 18 dargestellt im Folgenden wird auf die Einzelheiten der Syntheseschritte eingegangen.

### 1. Syntheseschritt: Synthese von 4-Octadec-17'-enyloxybenzonitril

| Ansatz: | | |
|---|---|---|
| 4-Hydroxybenzonitril: | 6,55 g | 55 mmol |
| KOMe: | 3,85 g | 54,9 mmol |
| CH₂Cl₂: | 75 ml | |
| 18-Bromoctadec-1-en: | 13,3 g | 40 mmol |
| DMF: | 75ml | |

Darstellung von Kaliumphenolat: In einem Kolben wird 4-Hydroxybenzonitril in CH₂Cl₂ vorgelegt und mit KOMe versetzt. Das Reaktionsgemisch wird 15 min bei Raumtemperatur gerührt, anschließend wird das Lösungsmittel im Vakuum vollständig entfernt.

Etherkupplung: Zum Kaliumphenolat wird DMF und das entsprechende Alkylbromid gegeben und auf 120°C erhitzt. Nach 2 h wird die Reaktion auf Raumtemperatur gebracht, mit Wasser versetzt und mit verdünnter HCl neutralisiert.

Aufarbeitung: Im Scheidetrichter wird die wässrige DMF-Phase mit Ether mehrmals extrahiert. Die organische Phase wird mit Wasser DMF-frei gewaschen und über MgSO₄ getrocknet. Nach Entfernen des Lösungsmittels und Reinigung über Kieselgel mit PE/CH₂Cl₂ (1: 1) als Laufmittel wird ein farblosen Feststoff erhalten.

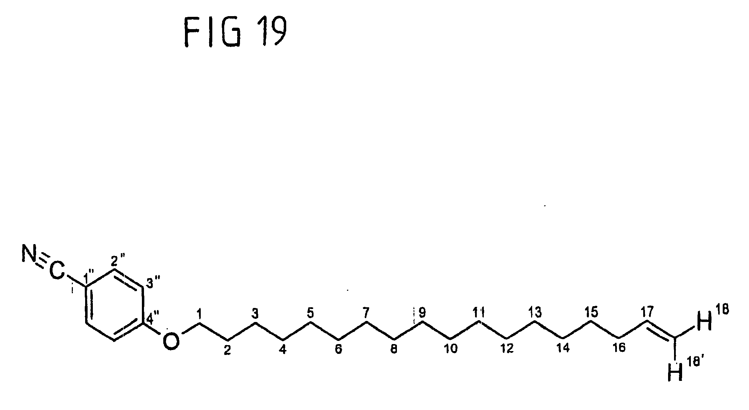

Ausbeute: 11,8 g (31,8 mmol) 80% 4-Octadec-17'-enyloxybenzonitril (siehe Fig. 19); farbloser Feststoff
Schmelztemperatur: 60 - 61°C

| Analyse: C₂₅H₃₉NO (M: 369,59 g/mol) | | | | | |
|---|---|---|---|---|---|
| | ber.: | C: 81,25 | H: 10,64 | N: 3,19 | O: 4,33 |
| | gef.: | C: 81,13 | H: 10,10 | N: 3,56 | O:- |

¹H-NMR: (500 MHz, CDCl₃)
1,22 bis 1,46 (m; 24H; H3-H15); 1,76 bis 1,82 (m; 2H; H2); 2,01 bis 2,06 (m; 2H; H16) ; 3,99 (t; 2H; H1; ³J_{1,2}= 6,6 Hz) ; 4,92 (m_{c}; 1H; H18) ; 4,99 (m_{c}; 1H; H18'); 5, 81 (ddt; 1H; H17; ³J_{17,18'} = 17,0 Hz; ³J_{17,18} = 10,2 Hz; J_{17,16} = 6, 9 Hz); 6,93 (m; 3H; H3"); 7,56 (m; 2H; H2")
¹³C-NMR: (126 MHz, CDCl₃)
25,9; 29,0; 29,0; 29,2; 29,3; 29,5; 29,5; 29,6; 29,6; 29,7; 29,7 (C2-C15) ; 33,8 (C16) ; 68,4 (C1) ; 103,7 (C1") ; 114,1 (C18) ; 115,2 (C3") ; 119,3 (CN); 133,9 (C2") ; 139,2 (C17) ; 162,5 (C4")

### 2. Syntheseschritt: Darstellung von 4-(18'-Trichlorsilyloctadecyloxy)benzonitril

| Ansatz: | | |
|---|---|---|
| 4-Octadec-17'-enyloxybenzonitril: | 5 g | 13,5 mmol |
| Trichlorsilan: | 24 ml | 234 mmol |
| Hexachloroplatinsäure-Lösung: | 100 µl | |

In einem ausgeheizten Zweihalskolben mit Rückflusskühler/Gasableitungsrohr mit Hahn/Argonballon und Gummiseptum wird 4-Octadec-17'-enyloxybenzonitril vorgelegt. Mit einer Spritze wird Trichlorsilan und die Katalysatorlösung zugegeben und es wird über Nacht bei Raumtemperatur gerührt. Nach dem Entfernen des überschüssigen Trichlorsilans im Wasserstrahlvakuum wird der Rückstand im Öfpumpenvakuum über eine Vigreux-Kolonne destilliert.

### Herstellung der Katalysatorlösung:

164 mg H₂PtCl₆ aq. werden in 10 ml abs. Isopropanol gelöst, Die Lösung wird bis zum vollständigen Lösen des Feststoffs gerührt und im Kühlschrank gelagert.

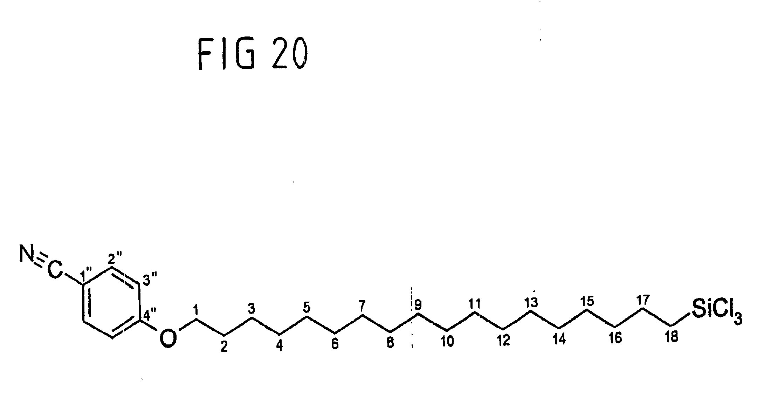

Ausbeute: 5,61 g (11,1 mmol) 82% 4- (18' - Trichlorsilyloctadecyloxy)benzonitril (siehe Fig. 20); farbloser Feststoff
Schmelztemperatur: 50°C
Siedetemperatur: 211-237°C bei 5 x 10⁻⁵ mbar

| MS: (EI 70 eV) C₂₅H₄₀Cl₃NOSi | | |
|---|---|---|
| | ber.: | 503,1945 |
| | gef.: | 503,1946 |

¹H-NMR: (500 MHz, CDCl₃)
1,22 bis 1,48 (m; 30H; H3 bis H17); 1,55 bis 1,61 (m; 4H; H18); 1,77 bis 1,82 (m; 2H; H2); 3,99 (t; 2H; H1; ³J_{1,2} = 6,6 Hz) ; 6,93 (m; 3H; H3"); 7,55 (m; 2H; H2")
¹³C-NMR: (126 MHz, CDCl₃)
22,2 (C18); 24,3 (C17); 25,9; 29,0; 29,3; 29,3; 29,5; 29,6; 29,6; 29,7 (C2-C15); 31,8 (C16); 68,4 (C1); 103,6 (C1"); 115,2 (C3"); 119,3 (CN); 134,0 (C2"); 162,5 (C4")

Mit Hilfe dieser ω-Halogen-Alk-1-ene (I) ist es möglich, selbstorganisierende Monolagen 11 zu bilden. Im Folgenden wird die Anwendung der synthesisierten Verbindungen beschrieben.

In Fig. 21 ist eine Strukturformel für eine Ausführungsform einer erfindungsgemäßen Verbindung dargestellt. Die Verbindung ist im Wesentlichen linear aufgebaut. An einem Ende ist eine Ankergruppe 1 angeordnet, die hier als Trichlorsilan ausgebildet ist. Diese Ankergruppe 1 erlaubt eine Bindung an ein hier nicht dargestelltes Substrat 10 (siehe Fig. 22). Oberhalb der Ankergruppe 1 ist eine dielektrische Gruppe 2 angeordnet, die als n-Alkyl ausgebildet ist. Die Kettenlänge beträgt n=2 bis 20. Am der Ankergruppe 1 entgegengesetzten Ende der Verbindung 5 ist eine Kopfgruppe 3 mit einem aromatischen System angeordnet. Diese Kopfgruppe 3 erlaubt eine n-n Wechselwirkung mit anderen Molekülen der gleichen Art und / oder Moleküle anderer Art zur Stabilisierung der Monolage 11.

Dies ist in Fig. 22 dargestellt, wobei hier Moleküle gleicher Art eine Monolage 11 bilden, die eine Schichtenstruktur aufweist. Die Ankergruppen 1 der Moleküle sind hier an eine hydroxylhaltige Schicht eines Substrates 10 gebunden. Zwischen den Kopfgruppen 3 können π-π Wechselwirkung stattfinden, so dass sich eine äußerst stabile Schichtenstruktur ausbildet.

Im Folgenden werden die Vorteile dieser Monolagen 11 (T-SAM) näher erläutert.

Chemische Stabilität: Die T-SAM ist inert gegenüber allen Reagenzien, die nicht die Anbindung an die Substratoberfläche zerstören. Gegenüber aggressiven Reagenzien sind die T-SAMs eine gewisse Zeit beständig, da die Reagenzien erst durch die Monolage 11 diffundieren bzw. diese seitlich angreifen müssen. Diese Robustheit wurde bisher an keiner anderen SAM-Klasse beobachtet.

Prozessstabilität: Die T-SAMs tolerieren lithografische Schritte, wie das Aufbringen von Photolack, eine Photostrukturierung, Nassentwicklung und das Strippen von Photolack. Damit ist es möglich, z.B. auf dielektrischen Schichten weitere Schichten zur Bildung eines organischen Feldeffekttransistors aufzubauen.

Zeitliche Stabilität und Lagerstabilität: Zwischen der Abscheidung und weiterer Prozessierung können mehrere Wochen liegen, ohne dass es zu einem Abbau der T-SAM kommt; die Monolagen 11 sind haltbar.

Metallabscheidung: Auf die T-SAMs können flächenhaft in nahezu 100 % Ausbeute elektrochemisch oder über die Gasphase Metalle abgeschieden werden, ohne dass Kurzschlüsse auftreten. Diese hohe dielektrische "Qualität" wurde bisher bei keiner anderen SAM-Klasse beobachtet.

Temperaturstabilität: Die T-SAMs sind bis Temperaturen oberhalb 200°C stabil.

Schichtdickenhomogenität: Die erhaltene Schichtdicke ist eine intrinsische Funktion der Molekülgeometrie und der Verankerung am Substrat. Schichtdickenschwankungen treten praktisch nicht auf.

Abschließend soll der Aufbau eines organischen Feldeffekttransistors erläutert werden, der Schichten aus den synthetisierten Verbindungen aufweist.

Organische Feldeffekttransistoren sind elektronische Bauteile, die aus mehreren Schichten (Lagen) bestehen, welche alle strukturiert sind, um durch Verbindungen einzelner Schichten integrierte Schaltungen zu generieren. Dabei zeigt Fig. 23 den prinzipiellen Aufbau eines solchen Transistors in einer Bottom-Kontakt Architektur.

Auf einem Basis-Substrat 20 ist eine Gateelektrode 21 angeordnet, die von einer Gatedielektrikumsschicht 22 überdeckt ist. Eine solche Gatedielektrikumssicht 22 kann z.B. aus einer oben beschriebenen Monolage 11 bestehen. Derartige Dielektrika besitzen eine Schichtdicke von weniger als 5 nm (Bottom up).

Auf der Gatedielektrikumsschicht 22 sind eine Sourceschicht 23a und eine Drainschicht 23b angeordnet, die beide mit einer darbüberliegenden aktiven halbleitenden Schicht 24 in Verbindung stehen. Über der aktiven Schicht 24 ist eine Passivierungsschicht 25 angeordnet.

Die Erfindung beschränkt sich in ihrer Ausführung nicht auf die vorstehend angegebenen bevorzugten Ausführungsbeispiele.

### Bezugszeichenliste

- 1: Ankergruppe
- 2: dielektrische Gruppe
- 3: Gruppe mit einer n-n Wechselwirkung (Kopfgruppe)
- 5: Verbindung zur Bildung einer selbstorganisierenden Schicht

- 10: Substrat
- 11: Monolage.aus Molekülen

- 20: Basis-Substrat für OFET
- 21: Gateelektrode
- 22: Gatedielektrikumsschicht
- 23a: Sourceschicht
- 23b: Drainschicht
- 24: aktive Halbleiterschicht
- 25: Passivierungsschicht

- 100: Halbleiterbauelement (organischer Feldeffekttransistor)

## Patentansprüche

1. Syntheseverfahren für eine Verbindung zur Bildung einer selbstorganisierenden Monolage, insbesondere einer Monolage für ein Halbleiterbauelement,
**gekennzeichnet durch**
a) einen ersten Syntheseschritt, bei dem bei einem ω-Halogen-Alk-1-en (I), 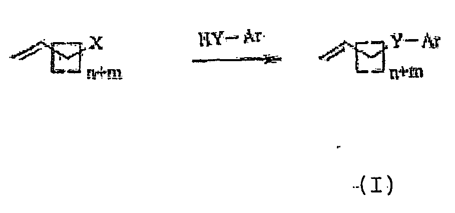 eine endständige nukleophile Substitution des Halogens mit einer Gruppe mit der Fähigkeit einer π-π Wechselwirkung, insbesondere einer Gruppe mit mindestens einer aromatischen Gruppe (Ar), erfolgt,
b) das Produkt des ersten Syntheseschritts in einem zweiten Syntheseschritt hydrosilyiert wird.

2. Syntheseverfahren nach Anspruch 1, **dadurch gekennzeichnet, dass** die Gruppe mit Fähigkeit einer π-π Wechselwirkung die Form
(II) HY - Ar
aufweist, wobei Y: O, S, Se oder NH ist.

3. Syntheseverfahren nach Anspruch 1 oder 2, **dadurch gekennzeichnet, dass** die aromatische Grupppe (Ar) mindestens eine der folgenden Gruppen aufweist: 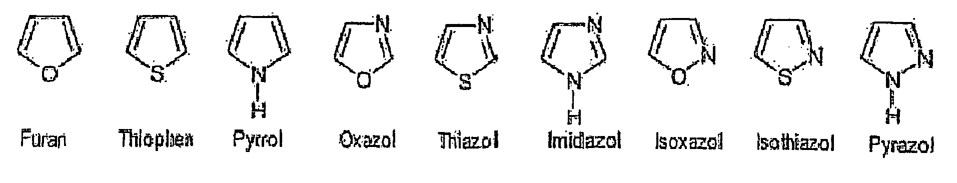 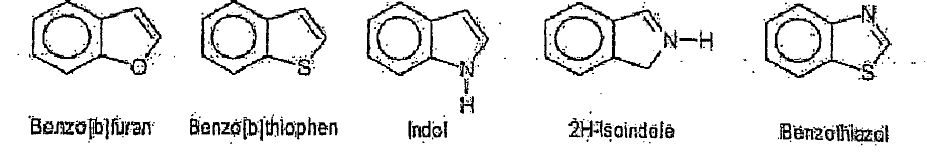 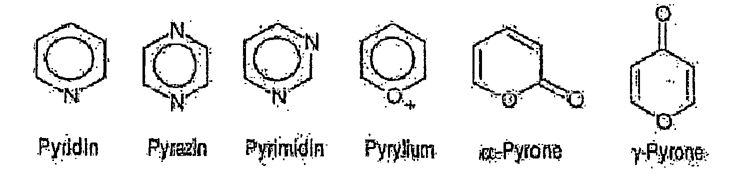 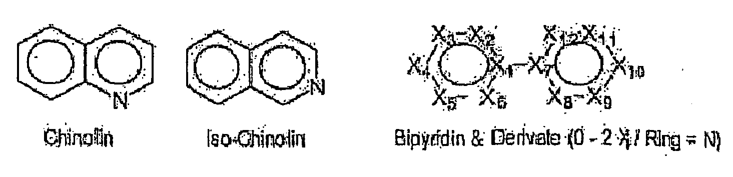 oder mindestens ein Naphtalen, Anthracen, Naphtacen, Pentacen, Biphenyl, Terphenyl, Quaterphenyl und / oder Quinquephenyl aufweist.

4. Syntheseverfahren nach mindestens einem der vorhergehenden Ansprüche, **dadurch gekennzeichnet, dass** die molekulare Gruppe mit der Fähigkeit einer n-n Wechselwirkung ein kondensiertes Aromat mit bis zu fünf Ringsystemen aufweist.

5. Syntheseverfahren nach mindestens einem der vorhergehenden Ansprüche, **dadurch gekennzeichnet, dass** die Hydrosilyierung des zweiten Synthesschrittes säurekatalysiert, insbesondere mit Hexachloroplatin (IV) säure, und / oder mit Toluol als Co-Lösungsmittel erfolgt

6. Syntheseverfahren nach mindestens einem der vorhergehenden Ansprüche, **dadurch gekennzeichnet, dass** die Hydrosilyierung des zweiten Syntheseschrittes mit einem Silan gemäß HSiZ₃ mit Z: Cl oder eine Alkoxy-Gruppe erfolgt.

7. Syntheseverfahren nach mindestens einem der vorhergehenden Ansprüche, **dadurch gekennzeichnet, dass** das ω-Halogen-Alk-1-en des ersten Syntheseschrittes durch eine Reaktion gemäß folgendem Reaktionsschema hergestellt wird: 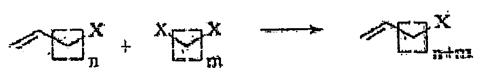 wobei
X: Halogen, insbesondere Cl, Br, I
n: 1 bis 12, insbesondere 6
m: 5 bis 15, insbesondere 10

8. Syntheseverfahren nach mindestens einem der vorhergehenden Ansprüche, **dadurch gekennzeichnet, dass** im ersten Syntheseschritt ein 18-Bromoctadec-1-en mit Kaliumphenolat und DMF zu Octadec-17-enyloxybenzol umgesetzt wird.

9. Syntheseverfahren nach mindestens einem der vorhergehenden Ansprüche, **dadurch gekennzeichnet, dass** im ersten Syntheseschritt ein 18-Bromoctadec-1-en mit Kaliumbiphenyl-4-olat und DMF zu 4-Octadec-17''-enyloxy-1,1'-biphenyl umgesetzt wird.

10. Syntheseverfahren nach mindestens einem der vorhergehenden Ansprüche, **dadurch gekennzeichnet, dass** im ersten Syntheseschritt ein 18-Bromoctadec-1-en mit 2-Thienyllithium und THF zu 2-Heptadec-16'-enylthiophen und /oder 2-Octadec-17'-enylthiophen umgesetzt wird.

11. Syntheseverfahren nach mindestens einem der vorhergehenden Ansprüche, **dadurch gekennzeichnet, dass** ein 4-Hydroxybenzonitril mittels einer Williamsonschen Ethersynthese mit 18-Bromoctadec-1-en mit und DMF zu 4-Octadec-17'enyloxybenzonitril umgesetzt wird.

12. Verbindung zur Bildung einer selbstorganisierenden Monolage, insbesondere einer Monolage für ein Halbleiterbauelement,
**dadurch gekennzeichnet, dass**
es als (18-Phenoxyoctadecyl)trichlorsilan,
[18-(1',1''-Biphenyl-4'-yloxy)octadecyl] trichlorsilan,
(17-Thien-2'-ylheptadecyl)trichlorsilan,
(18-Thien-2'-yloctadecyl)trichlorsilan oder
4-(18'-Trichlorsilyloctadecyloxy)benzonitril ausgebildet ist.

13. Schichtstruktur eines Halbleiterbauelementes mit einer molekularen Monolage, insbesondere eines organischen Feldeffekttransistors,
**gekennzeichnet durch**
mindestens eine Monolage (11), die mindestens eine Verbindung gemäß Anspruch 12 aufweist.

## Claims

1. Synthesis method for a compound used to form a self-assembled monolayer, in particular a monolayer for a semiconductor component,
**characterized by**
a) a first synthesis step in which, in the case of an ω-haloalk-1-ene (I), 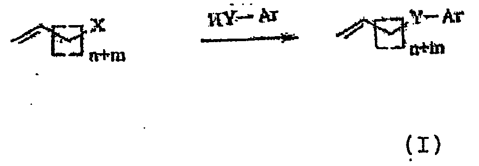 a terminal nucleophilic substitution of the halogen by a group capable of a π-π interaction, in particular a group having at least one aromatic group (Ar), is effected,
b) the product of the first synthesis step is hydrosilylated in a second synthesis step.

2. Synthesis method according to claim 1, **characterized in that** the group capable of a π-π interaction has the form
(II) HY - Ar
in which Y: O, S, Se or NH.

3. Synthesis method according to claim 1 or 2, **characterized in that** the aromatic group (Ar) has at least one of the following groups: 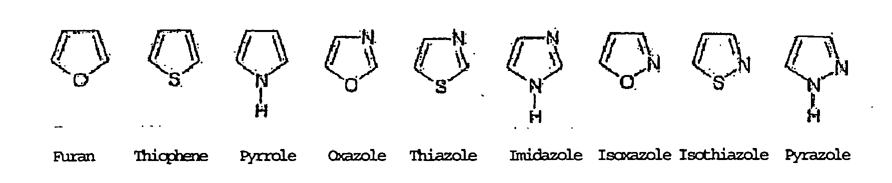 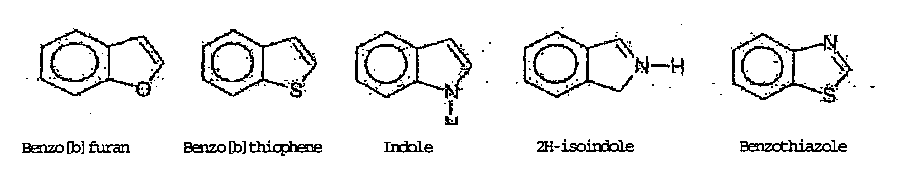 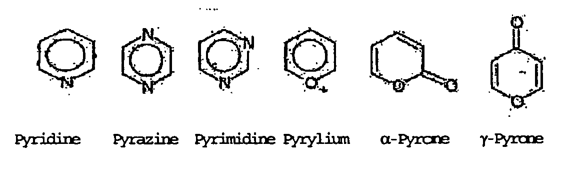 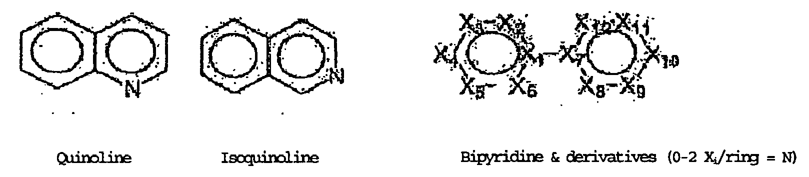 or has at least one naphthalene, anthracene, naphthacene, pentacene, biphenyl, terphenyl, quaterphenyl and/or quinquephenyl.

4. Synthesis method according to at least one of the preceding claims, **characterized in that** the molecular group capable of a π-π interaction has a condensed aromatic having up to five ring systems.

5. Synthesis method according to at least one of the preceding claims, **characterized in that** the hydrosilylation of the second synthesis step is effected under acid catalysis, in particular using hexachloroplatinic(IV) acid and/or using toluene as a cosolvent.

6. Synthesis method according to at least one of the preceding claims, **characterized in that** the hydrosilylation of the second synthesis step is effected using a silane according to HSiZ₃ where Z: Cl or an alkoxy group.

7. Synthesis method according to at least one of the preceding claims, **characterized in that** the ω-haloalk-1-ene of the first synthesis step is prepared by a reaction according to the following reaction scheme: 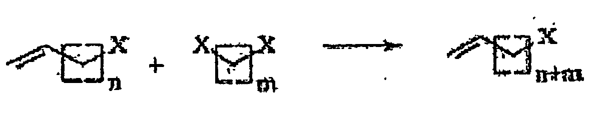
in which X: halogen, in particular Cl, Br, I
n: 1 to 12, in particular 6
m: 5 to 15, in particular 10

8. Synthesis method according to at least one of the preceding claims, **characterized in that**, in the first synthesis step, an 18-bromooctadec-1-ene is reacted with potassium phenolate and DMF to give octadec-17-enyloxybenzene.

9. Synthesis method according to at least one of the preceding claims, **characterized in that**, in the first synthesis step, an 18-bromooctadec-1-ene is reacted with potassium biphenyl-4-olate and DMF to give 4-octadec-17"-enyloxy-1,1'-biphenyl.

10. Synthesis method according to at least one of the preceding claims, **characterized in that**, in the first synthesis step, an 18-bromooctadec-1-ene is reacted with 2-thienyllithium and THF to give 2-heptadec-16'-enylthiophene and/or 2-octadec-17'-enylthiophene.

11. Synthesis method according to at least one of the preceding claims, **characterized in that** a 4-hydroxybenzonitrile is reacted with 18-bromooctadec-1-ene and DMF by means of a Williamson ether synthesis to give 4-octadec-17'-enyloxybenzonitrile.

12. Compound used to form a self-assembled monolayer, in particular a monolayer for a semiconductor component
**characterized in that** it is in the form of (18-phenoxyoctadecyl)trichlorosilane,
[18-(1',1"-biphenyl-4'-yloxy)octadecyl]trichlorosilane,
(17-thien-2'-ylheptadecyl)trichlorosilane,
(18-thien-2'-yloctadecyl)trichlorosilane or
4-(18'-trichlorosilyloctadecyloxy)benzonitrile.

13. Layer structure of a semiconductor component having a molecular monolayer, in particular of an organic field effect transistor,
**characterized by**
at least one monolayer (11) which comprises at least one compound according to claim 12.

## Revendications

1. Procédé de synthèse d'un composé pour la formation d'une monocouche auto-organisée, notamment d'une monocouche pour un composant à semi-conducteur,
**caractérisé par**
a) un premier stade de synthèse, dans lequel on effectue, pour un ω-halogéno-alc-1-ène (I), 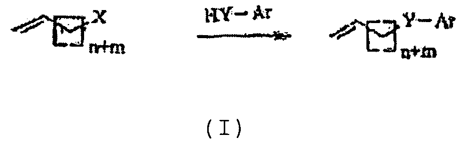 une substitution nucléophile d'extrémité de l'halogène par un groupe ayant la capacité d'une interaction π-π, notamment un groupe ayant au moins un groupe (Ar) aromatique,
b) on hydrosilyle le produit du premier stade de synthèse dans un deuxième stade de synthèse.

2. Procédé de synthèse suivant la revendication 1, **caractérisé en ce que** le groupe ayant la capacité d'une interaction π-π a la forme
(II) HY - Ar
Y étant O, S, Se ou NH.

3. Procédé de synthèse suivant la revendication 1 ou 2, **caractérisé en ce que** le groupe (Ar) aromatique a au moins l'un des groupes suivants : 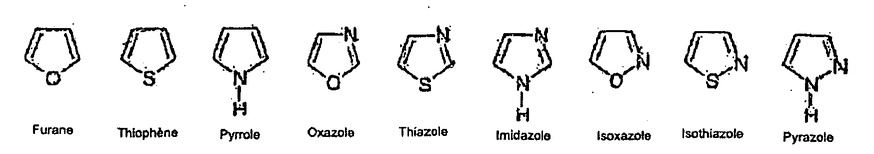 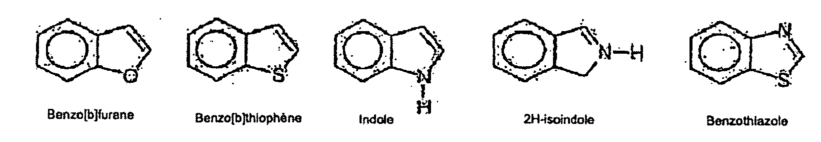 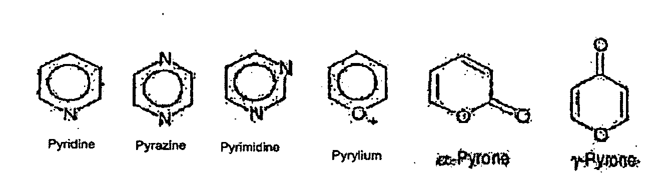 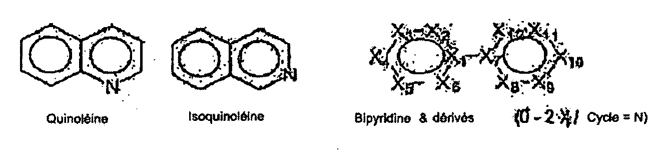 ou au moins un naphtalène, anthracène, naphtacène, pentacène, biphényle, terphényle, quaterphényle et/ou quinquéphényle.

4. Procédé de synthèse suivant au moins l'une des revendications précédentes, **caractérisé en ce que** le groupe moléculaire ayant la capacité d'une interaction π-π est un aromatique condensé ayant jusqu'à cinq systèmes cycliques.

5. Procédé de synthèse suivant au moins l'une des revendications précédentes, **caractérisé en ce que** l'on effectue l'hydrosilylation du deuxième stade de synthèse par catalyse acide, notamment par de l'acide hexachloroplatinique (IV) et/ou par du toluène en tant que cosolvant.

6. Procédé de synthèse suivant au moins l'une des revendications précédentes, **caractérisé en ce qu'**on effectue l'hydrosilylation du deuxième stade de synthèse par un silane suivant HSiZ₃, avec Z:Cl ou un groupe alcoxy.

7. Procédé de synthèse suivant au moins l'une des revendications précédentes, **caractérisé en ce que** l'on prépare le ω-halogéno-alc-1-ène du premier stade de synthèse par une réaction selon le schéma de réaction suivant : 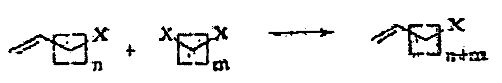
dans lequel X : halogène, notamment Cl, Br, I
n : 1 à 12, notamment 6
m : 5 à 15, notamment 10

8. Procédé de synthèse suivant au moins l'une des revendications précédentes, **caractérisé en ce que**, dans le premier stade de synthèse, on fait réagir un 18-bromooctadec-1-ène sur du phénolate de potassium et du DMF pour obtenir de l'octadec-17-ényloxybenzène.

9. Procédé de synthèse suivant au moins l'une des revendications précédentes, **caractérisé en ce que**, dans le premier stade de synthèse, on fait réagir un 18-bromooctadec-1-ène sur du biphényl-4-olate de potassium et du DMF pour obtenir du 4-octadec-17"-ényloxy-1,1'-biphényle.

10. Procédé de synthèse suivant au moins l'une des revendications précédentes, **caractérisé en ce que**, dans le premier stade de synthèse, on fait réagir du 18-bromooctadec-1-ène sur du 2-lithiumthiényle et du THF pour obtenir du 2-heptadec-16'-énylthiophène et/ou du 2-octadec-17'-énylthiophène.

11. Procédé de synthèse suivant au moins l'une des revendications précédentes, **caractérisé en ce que** l'on fait réagir un 4-hydroxybenzonitrile au moyen d'une synthèse d'éther de Williamson sur du 18-bromooctadec-1-ène et du DMF pour obtenir du 4-octadec-17'-ényloxybenzonitrile.

12. Composé pour la formation d'une monocouche auto-organisée, notamment d'une monocouche pour un composant à semi-conducteur, **caractérisé en ce qu'**il est constitué sous la forme
du 18-phénoxyoctadécyl)trichlorosilane,
du [18-(1',1''-biphényl-4'-yloxy)octadécyl]tri-chlorosilane,
du (17-thien-2'-ylheptadécyl)trichlorosilane,
du (18-thien-2'-yloctadécyl)trichlorosilane ou
du 4-(18'-trichlorosilyloctadécyloxy)benzonitrile.

13. Structure stratifiée d'un composant à semi-conducteur ayant une monocouche moléculaire, notamment d'un transistor à effet de champ organique,
**caractérisée**
**par** au moins une monocouche (11) qui a au moins un composé suivant la revendication 12.
